# EUROPEAN PATENT APPLICATION

(11) **EP 3 968 127 A1**
(43) Date of publication of application: **16.03.2022**
(21) Application number: 20806283.6
(22) Date of filing: 07.05.2020
(51) Int. Cl.: G06F 1/20, H05K 7/20

(54) **ELECTRONIC DEVICE COMPRISING HEAT TRANSFER STRUCTURE**

(30) Priority: 10.05.2019 KR 20190054936
(71) Applicant: Samsung Electronics Co., Ltd., Suwon-si, Gyeonggi-do 16677 (KR)
(72) Inventor: SONG, Yongjae, Suwon-si Gyeonggi-do 16677 (KR); YEO, Moonki, Suwon-si Gyeonggi-do 16677 (KR); YOON, Chongo, Suwon-si Gyeonggi-do 16677 (KR); KIM, Jihong, Suwon-si Gyeonggi-do 16677 (KR); LEE, Kyuhwan, Suwon-si Gyeonggi-do 16677 (KR); LEE, Haejin, Suwon-si Gyeonggi-do 16677 (KR); CHO, Chihyun, Suwon-si Gyeonggi-do 16677 (KR); CHOI, Jongchul, Suwon-si Gyeonggi-do 16677 (KR); HEO, Changryong, Suwon-si Gyeonggi-do 16677 (KR)
(74) Representative: Arnold & Siedsma
(86) International application number: PCT/KR2020/006034
(87) International publication number: WO 2020/231083

(57) **Abstract**

Various embodiments related to an electronic device comprising a heat transfer structure have been described. According to one embodiment, an electronic device comprises: a hinge structure; a first housing structure rotatably connected through the hinge structure; a second housing structure rotatably connected through the hinge structure, and facing the first housing structure on the basis of the hinge structure in a folded status a first fastening member mounted on the hinge structure; a second fastening member mounted on the hinge structure, separated from the first fastening member in the folded status, and coupled to the first fastening member in an unfolded status of the first housing structure and the second housing structure; a first printed circuit board disposed in the first housing structure and having at least one first element mounted thereon; a first heat transfer structure disposed on at least a portion of the first housing structure and at least a portion of the hinge structure; and a second heat transfer member disposed on at least a portion of the second housing structure and at least a portion of the hinge structure, wherein the first heat transfer structure may comprise: a first heat transfer region facing at least a partial surface of the at least one first element; and a first heat transfer member disposed on at least a partial surface of the first heat transfer region and at least a portion of the first fastening member, and in the unfolded status, at least a portion of the first heat transfer member and at least a portion of the second heat transfer member face each other, and in the folded status, the first heat transfer and the second heat transfer member may be configured to be separated from each other. Various other embodiments are possible.

## Description

### [Technical Field]

Various embodiments of the disclosure relate to an electronic device including a heat transfer structure.

### [Background Art]

In line with the remarkable development of information and communication technology and semiconductor technology, the proliferation and use of various electronic devices are rapidly increasing. In particular, recent electronic devices have been developed to be portable for communication.

Electronic devices may indicate devices that perform a specific function according to a loaded program, such as electronic notebooks, portable multimedia players, mobile communication terminals, tablet PCs, image/audio devices, desktop/laptop computers, vehicle navigation devices, as well as home appliances. For example, these electronic devices may output stored information as sound or images. As the degree of integration of electronic devices increases and high-speed and large-capacity wireless communication becomes common, a single electronic device such as a mobile communication terminal has been equipped with various functions in recent years. For example, entertainment functions such as games, multimedia functions such as music/video playback, communication and security functions for mobile banking, etc., and functions such as schedule management, electronic wallets, etc., as well as communication functions, are integrated into one electronic device. Such electronic devices are being miniaturized so that users can conveniently carry them.

As the mobile communication service extends to the multimedia services, the size of the display of the electronic device may increase in order for the user to fully use the multimedia services as well as voice calls or short messages. Accordingly, a foldable display may be disposed in the entire region of a housing structure separated so as to be foldable.

### [Detailed Description of the Invention]

### [Technical Problem]

An electronic device having a foldable structure may include first and second housing structures, which may be connected by a hinge structure disposed between the first and second housing structures. A printed circuit board including elements (e.g., an antenna module, a communication module, or a processor) may be mounted to each of the first and second housing structures, and these elements may emit high-temperature heat during operation such as signal processing. At this time, if the high-temperature heat is concentrated in one of the first and second housing structures, performance of the electronic device may be deteriorated. Accordingly, an environment in which the housing can be cooled by transferring or diffusing the high-temperature heat of the housing to the other housing having a relatively low temperature may be necessary.

According to an embodiment of the disclosure, it is possible to provide an electronic device including a heat transfer structure in which heat generated in the housing structure in a high-temperature state, among the first and second housing structures, is transferred, diffused, or dispersed to the other housing structure in a lower-temperature state or is discharged to the outside for cooling.

### [Technical Solution]

According to various embodiments of the disclosure, an electronic device may include a hinge structure, a first housing structure rotatably connected through the hinge structure, a second housing structure rotatably connected through the hinge structure and facing the first housing structure with respect to the hinge structure in a folded status, a first fastening member mounted on the hinge structure, a second fastening member mounted on the hinge structure, and configured to be separated from the first fastening member in the folded status and be coupled to the first fastening member in an unfolded status of the first housing structure and the second housing structure, a first printed circuit board disposed in the first housing structure and having at least one first element mounted thereon, a first heat transfer structure disposed in at least a portion of the first housing structure and in at least a portion of the hinge structure, and a second heat transfer member disposed in at least a portion of the second housing structure and in at least a portion of the hinge structure, wherein the first heat transfer structure may include a first heat transfer region facing at least a partial surface of the at least one first element, and a first heat transfer member disposed in at least a partial surface of the first heat transfer region and in at least a portion of the first fastening member, and wherein at least a portion of the first heat transfer member and at least a portion of the second heat transfer member face each other in the unfolded status, and the first heat transfer member and the second heat transfer member are separated in the folded status.

According to various embodiments of the disclosure, an electronic device may include a hinge structure, a first housing structure rotatably connected through the hinge structure, a second housing structure rotatably connected through the hinge structure and facing the first housing structure with respect to the hinge structure in a folded status, a first fastening member mounted on the hinge structure, a second fastening member mounted on the hinge structure, and configured to be separated from the first fastening member in the folded status and be coupled to the first fastening member in an unfolded status of the first housing structure and the second housing structure, a first printed circuit board disposed in the first housing structure and having at least one first element mounted thereon, a second printed circuit board disposed in the second housing structure and having at least one second element mounted thereon, and a heat transfer structure disposed in at least portions of the first housing and the second housing structure and in at least a portion of the hinge structure, wherein the heat transfer structure may include a first heat transfer region facing at least a partial surface of the at least one first element, a second heat transfer region facing at least a partial surface of the at least one second element, and a heat transfer member disposed between the first heat transfer region and the second heat transfer region and facing at least partial surfaces of the first heat transfer region and the second heat transfer region.

According to various embodiments of the disclosure, an electronic device may include a hinge structure, a first housing structure rotatably connected through the hinge structure, a second housing structure rotatably connected through the hinge structure and facing the first housing structure with respect to the hinge structure in a folded status, a first fastening member mounted on the hinge structure, a second fastening member mounted on the hinge structure, and configured to be separated from the first fastening member in the folded status and be coupled to the first fastening member in an unfolded status of the first housing structure and the second housing structure, a first printed circuit board disposed in the first housing structure and having at least one first element mounted thereon, a second printed circuit board disposed in the second housing structure and having at least one second element mounted thereon, a first heat transfer structure disposed in at least a portion of the first housing structure and in at least a portion of the hinge structure, and a second heat transfer structure disposed in at least a portion of the second housing structure and in at least a portion of the hinge structure, wherein the first heat transfer structure may include a first heat transfer region facing at least a partial surface of the at least one first element, and a first heat transfer member disposed in at least a partial surface of the first heat transfer region and in at least a portion of the first fastening member, wherein the second heat transfer structure may include a second heat transfer region facing at least a partial surface of the at least one second element, and a second heat transfer member disposed in at least a partial surface of the second heat transfer region and in at least a portion of the second fastening member, wherein at least a portion of the first heat transfer member and at least a portion of the second heat transfer member face each other in the unfolded status, and the first heat transfer member and the second heat transfer member may be separated in the folded status, and wherein, in the unfolded status, the first heat transfer member may transfer, to the second heat transfer member, heat of the at least one first element transferred to the first heat transfer region, and the second heat transfer member may transfer, to the first heat transfer member, heat of the at least one second element transferred to the second heat transfer region.

### [Advantageous Effects]

According to various embodiments of the disclosure, in an electronic device including a heat transfer member, for example, heat of a housing structure in a high-temperature state due to heat generated from at least one element provided in an electronic device can be transferred to the other housing structure in a lower-temperature state so as to perform cooling through transfer, diffusion, dispersion, or external discharge of the heat generated from at least one element, thereby improving the heat dissipation efficiency of the electronic device.

### [Brief Description of Drawings]

FIG. 1 is a block diagram of an electronic device in a network environment, according to various embodiments.
FIG. 2 is a diagram illustrating an unfolded state of an electronic device according to various embodiments of the disclosure.
FIG. 3 is a diagram illustrating a folded state of the electronic device in FIG. 3 according to various embodiments of the disclosure.
FIG. 4 is an exploded perspective view of an electronic device according to various embodiments of the disclosure.
FIG. 5A is a diagram illustrating heat distribution and heat transfer paths of some elements included in a foldable electronic device when the foldable electronic device is in an unfolded state according to various embodiments of the disclosure.
FIG. 5B is a cross-sectional view taken along line A-A' in FIG. 5A, which is a side cross-sectional view illustrating the configuration of a heat transfer structure.
FIG. 6 is an enlarged cross-sectional view of the portion K in FIG. 5B, which is a view illustrating the configuration of a heat transfer structure when an electronic device is in an unfolded state according to various embodiments of the disclosure.
FIG. 7 is an enlarged cross-sectional view of the portion K in FIG. 5B, which is a view illustrating the configuration of a heat transfer structure when an electronic device is in a folded state according to various embodiments of the disclosure.
FIG. 8 is a side cross-sectional view illustrating another embodiment of a heat transfer structure when an electronic device is in an unfolded state according to various embodiments of the disclosure.
FIG. 9 is a side cross-sectional view illustrating another embodiment of a heat transfer structure when an electronic device is in an unfolded state according to various embodiments of the disclosure.
FIG. 10A is a side cross-sectional view illustrating another embodiment of first and second fastening members when an electronic device is in an unfolded state according to various embodiments of the disclosure.
FIG. 10B is a side cross-sectional view illustrating another embodiment of first and second fastening members when an electronic device is in a folded state according to various embodiments of the disclosure.
FIG. 10C is a side cross-sectional view illustrating another embodiment of first and second fastening members when an electronic device is in an unfolded state according to various embodiments of the disclosure.
FIG. 10D is a side cross-sectional view illustrating another embodiment of first and second fastening members when an electronic device is in a folded state according to various embodiments of the disclosure.
FIG. 11A is a diagram illustrating heat distribution and heat transfer paths of some elements included in a foldable electronic device when the foldable electronic device is in an unfolded state according to various other embodiments of the disclosure.
FIG. 11B is a cross-sectional view taken along line B-B' in FIG. 11A, which is a side cross-sectional view illustrating another configuration of a heat transfer region in a heat transfer structure.
FIG. 12A is a diagram illustrating heat distribution and heat transfer paths of some elements included in a foldable electronic device when the foldable electronic device is in an unfolded state according to various other embodiments of the disclosure.
FIG. 12B is a cross-sectional view taken along line C-C' in FIG. 12A, which is a side cross-sectional view illustrating another configuration of a heat transfer region in a heat transfer structure.
FIG. 13 is a diagram illustrating another configuration of a heat transfer structure when an electronic device is in an unfolded state according to various embodiments of the disclosure.
FIG. 14A is a diagram illustrating heat distribution and heat transfer paths of some elements included in a foldable electronic device when the foldable electronic device is in an unfolded state according to various other embodiments of the disclosure.
FIG. 14B is a cross-sectional view taken along line D-D' in FIG. 14A, which is a side cross-sectional view illustrating another configuration of a heat transfer member in a heat transfer structure.
FIG. 15A is an enlarged cross-sectional view of the portion G in FIG. 14B, which is an enlarged side cross-sectional view illustrating another configuration of a heat transfer member among the configurations of a heat transfer structure when an electronic device is in an unfolded state according to various embodiments of the disclosure.
FIG. 15B is an enlarged cross-sectional view of the portion G in FIG. 14B, which is a side cross-sectional view illustrating another configuration of a heat transfer member among the configurations of a heat transfer structure when an electronic device is in a folded state according to various embodiments of the disclosure.
FIG. 16 is an enlarged cross-sectional view of D-D' in FIG. 14A, which is a side cross-sectional view illustrating another configuration of a heat transfer region in a heat transfer structure when an electronic device is in an unfolded state according to various embodiments of the disclosure.
FIG. 17A is a diagram illustrating heat distribution and heat transfer paths of some elements included in a foldable electronic device when the foldable electronic device is in an unfolded state according to various other embodiments of the disclosure.
FIG. 17B is an enlarged cross-sectional view taken along line E-E' in FIG. 17A, which is a side cross-sectional view illustrating another configuration of a heat transfer region in a heat transfer structure when an electronic device is in an unfolded state according to various embodiments of the disclosure.
FIG. 18 is a diagram illustrating another configuration of a heat transfer structure when an electronic device is in an unfolded state according to various embodiments of the disclosure.

### [Mode for Carrying out the Invention]

Various changes and modifications may be made to the disclosure, and the disclosure may have various embodiments, some of which will be described in detail with reference to the drawings. However, it should be appreciated that they are not intended to limit the disclosure to specific embodiments, and the disclosure cover all changes and modifications, equivalents, or alternatives falling within the spirit and technical scope of the disclosure.

With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases.

The terms including an ordinal number, such as expressions "a first" and "a second" may be used to described various elements, but the corresponding elements are not limited by such terms. These terms are used merely to distinguish between one element and any other element. For example, a first element may be termed a second element, and similarly, a second element may be termed a first element without departing from the scope of the disclosure. The term "and/or" includes combinations of one or more relevant mentioned items or any one of one or more relevant mentioned items. It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

Further, relative terms described as viewed from the drawings, such as "front surface", "rear surface", "top surface", and "bottom surface", may be replaced by ordinal numbers such as "first" and "second". In the ordinal numbers such as "first" and "second", the order of them is determined in the mentioned order or arbitrarily and may be arbitrarily changed as necessary.

The terms used in the disclosure are merely used to describe specific embodiments, and are not intended to limit the disclosure. A singular expression may include a plural expression unless they are definitely different in a context. As used herein, the expression "include" or "have" are intended to specify the existence of mentioned features, numbers, steps, operations, elements, components, or combinations thereof, and should be construed as not precluding the possible existence or addition of one or more other features, numbers, steps, operations, elements, components, or combinations thereof.

Unless defined otherwise, all terms used herein, including technical and scientific terms, have the same meaning as those commonly understood by a person skilled in the art to which the disclosure pertains. Such terms as those defined in a generally used dictionary may be interpreted to have the meanings equal to the contextual meanings in the relevant field of art, and are not to be interpreted to have ideal or excessively formal meanings unless clearly defined in the disclosure. In some cases, even the term defined in the disclosure should not be interpreted to exclude embodiments of the disclosure.

In the disclosure, an electronic device may be any device including a touch panel, and the electronic device may be called a terminal, a portable terminal, a mobile terminal, a communication terminal, a portable communication terminal, a portable mobile terminal, or a display device.

For example, the electronic device may be a smartphone, a mobile phone, a navigation device, a game player, a TV, a head unit for a vehicle, a notebook computer, a laptop computer, a tablet personal computer (PC), a personal media player (PMP), a personal digital assistant (PDA), and the like. The electronic device may be implemented as a pocket-sized portable communication terminal with a wireless communication function. Further, the electronic device may be a flexible device or a flexible display device.

The electronic device may communicate with an external electronic device such as a server, or perform an operation by interworking with the external electronic device. For example, the electronic device may transmit an image photographed by a camera and/or position information detected by a sensor unit to the server via a network. The network may be, but not limited to, a mobile or cellular communication network, a local area network (LAN), a wireless local area network (WLAN), a wide area network (WAN), an Internet, or a small area network (SAN).

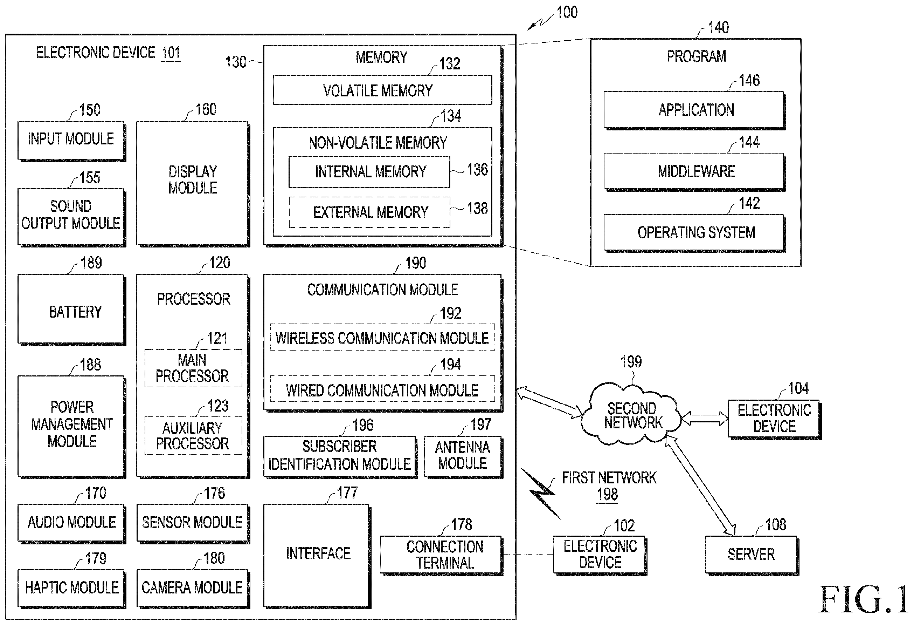

FIG. 1 is a block diagram illustrating an electronic device 101 in a network environment 100 according to various embodiments. Referring to FIG. 1, the electronic device 101 in the network environment 100 may communicate with an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input device 150, a sound output device 155, a display device 160, an audio module 170, a sensor module 176, an interface 177, a haptic module 179, a camera module 180, a power management module 188, a battery 189, a communication module 190, a subscriber identification module (SIM) 196, or an antenna module 197. In some embodiments, at least one (e.g., the display device 160 or the camera module 180) of the components may be omitted from the electronic device 101, or one or more other components may be added in the electronic device 101. In some embodiments, some of the components may be implemented as single integrated circuitry. For example, the sensor module 176 (e.g., a fingerprint sensor, an iris sensor, or an illuminance sensor) may be implemented as embedded in the display device 160 (e.g., a display).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may load a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), and an auxiliary processor 123 (e.g., a graphics processing unit (GPU), an image signal processor (ISP), a sensor hub processor, or a communication processor (CP)) that is operable independently from, or in conjunction with, the main processor 121. Additionally or alternatively, the auxiliary processor 123 may be adapted to consume less power than the main processor 121, or to be specific to a specified function. The auxiliary processor 123 may be implemented as separate from, or as part of the main processor 121.

The auxiliary processor 123 may control, for example, at least some of functions or states related to at least one component (e.g., the display device 160, the sensor module 176, or the communication module 190) among the components of the electronic device 101, instead of the main processor 121 while the main processor 121 is in an inactive (e.g., sleep) state, or together with the main processor 121 while the main processor 121 is in an active (e.g., executing an application) state. According to an embodiment, the auxiliary processor 123 (e.g., an image signal processor or a communication processor) may be implemented as part of another component (e.g., the camera module 180 or the communication module 190) functionally related to the auxiliary processor 123.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input device 150 may receive a command or data to be used by a component (e.g., the processor 120) of the electronic device 101, from the outside (e.g., a user) of the electronic device 101. The input device 150 may include, for example, a microphone, a mouse, a keyboard, or a digital pen (e.g., a stylus pen).

The sound output device 155 may output sound signals to the outside of the electronic device 101. The sound output device 155 may include, for example, a speaker or a receiver. The speaker may be used for general purposes, such as playing multimedia or playing record, and the receiver may be used for incoming calls. According to an embodiment, the receiver may be implemented as separate from, or as part of the speaker.

The display device 160 may visually provide information to the outside (e.g., a user) of the electronic device 101. The display device 160 may include, for example, a display, a hologram device, or a projector and control circuitry to control a corresponding one of the display, hologram device, and projector. According to an embodiment, the display device 160 may include touch circuitry adapted to detect a touch, or sensor circuitry (e.g., a pressure sensor) adapted to measure the intensity of force incurred by the touch.

The audio module 170 may convert a sound into an electrical signal, or in another example, may convert an electrical signal into a sound. According to an embodiment, the audio module 170 may obtain the sound via the input device 150, or output the sound via the sound output device 155 or an external electronic device (e.g., an electronic device 102 (e.g., a speaker or a headphone)) directly or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image and moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and support a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a cellular network, the Internet, or a computer network (e.g., LAN or wide area network (WAN)). These various types of communication modules may be implemented as a single component (e.g., a single chip), or may be implemented as one or more components (e.g., one or more chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., PCB). According to an embodiment, the antenna module 197 may include one or more antennas. In such a case, at least one antenna appropriate for a communication scheme used in the communication network, such as the first network 198 or the second network 199, may be selected, for example, by the communication module 190 from the one or more antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the external electronic devices 102 and 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, or client-server computing technology may be used, for example.

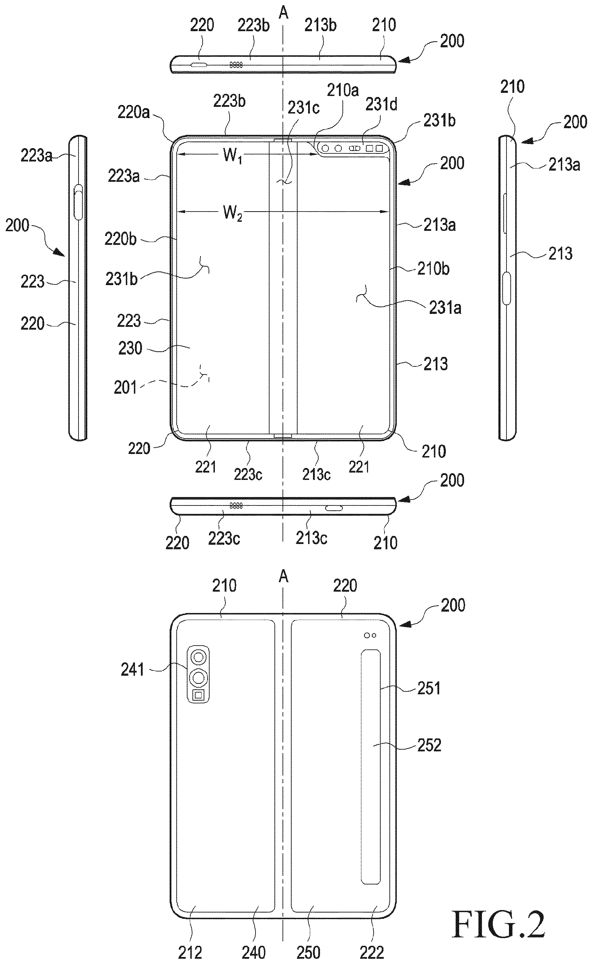

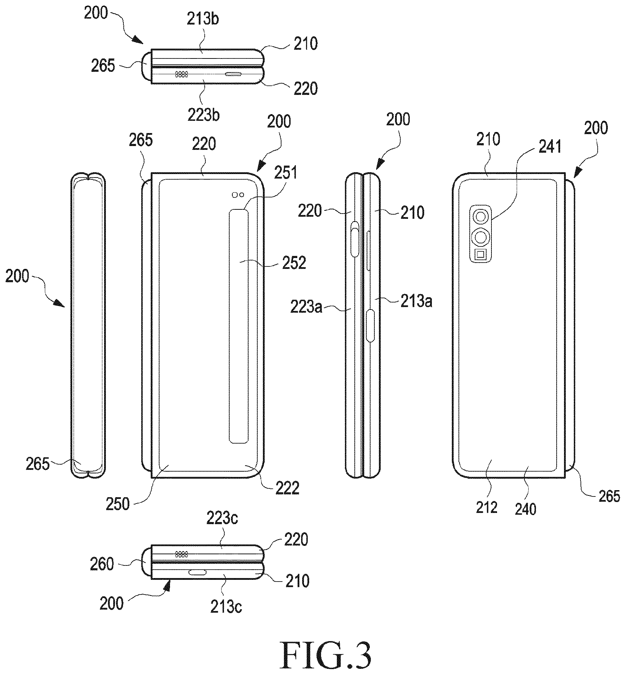

FIG. 2 is a diagram illustrating an unfolded state of an electronic device 200 according to various embodiments of the disclosure. FIG. 3 is a diagram illustrating a folded state of the electronic device 200 in FIG. 2 according to various embodiments of the disclosure.

The electronic device 200 in FIGS. 2 and 3 may be at least partially similar to the electronic device 101 in FIG. 1 or include another embodiment of the electronic device.

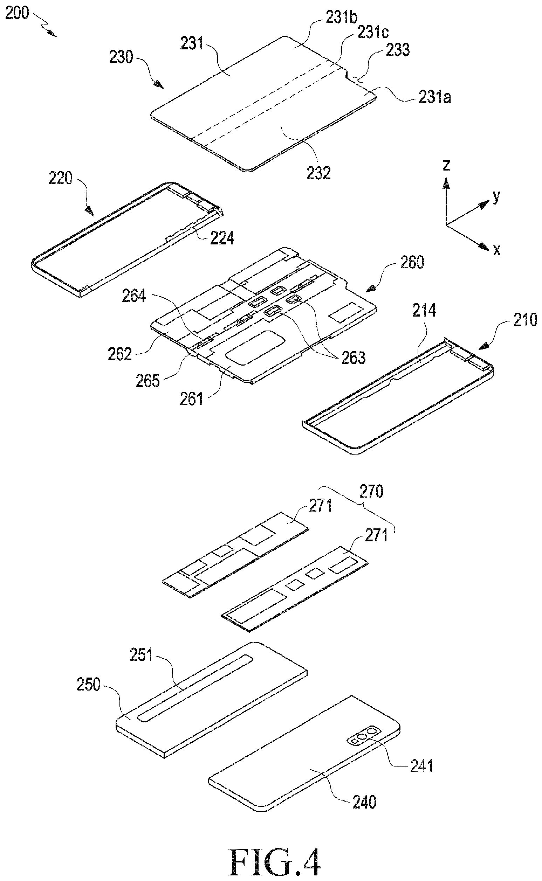

Referring to FIG. 2, the electronic device 200 may include a pair of housing structures 210 and 220 rotatably combined through a hinge structure (e.g., the hinge structure 264 in FIG. 4) to be folded against each other, a hinge cover 265 for covering the foldable portions of the pair of housing structures 210 and 220, and a display 230 (e.g., a flexible display or a foldable display) disposed in a space formed by the pair of housing structures 210 and 220. In some embodiments, the hinge cover 265 may be part of the hinge structure 264. In an embodiment, the electronic device 200 may include a foldable housing in which the pair of housing structures 210 and 220 are combined to be able to rotate from a folded position in which they face each other to a position in which they are parallel to each other. In this document, the surface on which the display 230 is disposed may be defined as a front surface of the electronic device 200, and the opposite surface of the front surface may be defined as a rear surface of the electronic device 200. In addition, the surface surrounding the space between the front surface and the rear surface may be defined as a side surface of the electronic device 200.

In an embodiment, the pair of housing structures 210 and 220 may include a first housing structure 210 including a sensor region 231d, a second housing structure 220, a first rear cover 240, and a second rear cover 250. The pair of housing structures 210 and 220 of the electronic device 200 are not limited to the form and coupling shown in FIGS. 2 and 3, and may be implemented by a combination and/or coupling of other shapes or components. For example, in another embodiment, the first housing structure 210 and the first rear cover 240 may be integrally formed, and the second housing structure 220 and the second rear cover 250 may be integrally formed.

According to an embodiment, the first housing structure 210 and the second housing structure 220 may be disposed on both sides about a first axis, for example, a folding axis A, and have an overall symmetrical shape about the folding axis A. In some embodiments, the first housing structure 210 and the second housing structure 220 may rotate about different folding axes with respect to the hinge structure 264 or the hinge cover 265. For example, the first housing structure 210 and the second housing structure 220 may be rotatably connected to the hinge structure 264 or the hinge cover 265, respectively, and may rotate about the folding axis A or different folding axes from each other, respectively, between the position at which they are folded and the position at which they are inclined with respect to each other or the position at which they are parallel to each other.

In this document, "positioned parallel to each other" or "extended parallel to each other" may indicate the state in which two structures are at least partially positioned next to each other or the state in which the parts positioned next to each other are arranged in parallel. In some embodiments, "arranged in parallel with each other" may indicate that two structures are positioned next to each other while facing in a parallel direction or in the same direction. In the following detailed description, although expressions such as "next to", "parallel", and the like will be used, these will be easily understood according to the shape or arrangement relationship of the structures with reference to the accompanying drawings.

According to an embodiment, the angle or distance between the first housing structure 210 and the second housing structure 220 may vary depending on whether the electronic device 200 is in an unfolded state (flat state or open state), a folded state, or an intermediate state. According to an embodiment, although the first housing structure 210, unlike the second housing structure 220, further includes a sensor region 231d in which various sensors are disposed, the remaining regions, excluding the same, may be symmetrical with each other. In another embodiment, the sensor disposed region 231d may be further disposed in at least a partial region of the second housing structure 220 or may replace the same.

In an embodiment, the first housing structure 210 may include a first surface 211 connected to the hinge structure (e.g., the hinge structure 264 in FIG. 4) and disposed to face the front surface of the electronic device 200 in the unfolded state of the electronic device 200, a second surface 212 facing in the opposite direction of the first surface 211, and a first side member 213 surrounding at least a portion of the space between the first surface 211 and the second surface 212. In an embodiment, the first side member 213 may include a first side surface 213a disposed parallel to the folding axis A, a second side surface 213b extending perpendicular to the folding axis A from one end of the first side surface 213a, and a third side surface 213c extending perpendicular to the folding axis A from the opposite end of the first side surface 213a. In describing various embodiments of the disclosure, although expressions such as "parallel" or "perpendicular" are used in relation to the arrangement relationship of the side surfaces described above, these may encompass the meaning of "partially parallel" or "partially perpendicular" depending on the embodiment. In some embodiments, expressions such as "parallel" or "perpendicular" may include an inclined arrangement relationship in an angular range within 10 degrees.

In an embodiment, the second housing structure 220 may include a third surface 221 connected to the hinge structure (e.g., the hinge structure 264 in FIG. 4) and disposed to face the front surface of the electronic device 200 in the unfolded status of the electronic device 200, a fourth surface 222 facing in the opposite direction of the third surface 221, and a second side member 223 surrounding at least a portion of the space between the third surface 221 and the fourth surface 222. In an embodiment, the second side member 223 may include a fourth side surface 223a disposed parallel to the folding axis A, a fifth side surface 223b extending perpendicular to the folding axis A from one end of the fourth side surface 223a, and a sixth side surface 223c extending perpendicular to the folding axis A from the opposite end of the fourth side surface 223a. In an embodiment, the third surface 221 may face the first surface 211 in the folded state. In some embodiments, although there may be some differences in the specific shape, the second side member 223 may be manufactured in substantially the same shape or material as the first side member 213.

In an embodiment, the electronic device 200 may include a recess 201 formed to receive the display 230 through structural shape coupling of the first housing structure 210 and the second housing structure 220. The recess 201 may have substantially the same size as the display 230. In an embodiment, due to the sensor region 231d, the recess 201 may have two or more different widths in the direction perpendicular to the folding axis A. For example, the recess 201 may have a first width W1 between a first portion 220a of the second housing structure 220, which is parallel to the folding axis A, and a first portion 210a formed at the periphery of the sensor region 231d in the first housing structure 210, and a second width W2 formed by a second portion 220b of the second housing structure 210 and a second portion 210b of the first housing structure 210, which does not fall in the sensor region 213d and is parallel to the folding axis A. In this case, the second width W2 may be formed to be larger than the first width W1. For example, the recess 201 may be formed to have a first width W1 formed between the first portion 210a of the first housing structure 210 and the first portion 220a of the second housing structure 220, which have an asymmetrical shape, and a second width W2 formed between the second portion 210b of the first housing structure 210 and the second portion 220b of the second housing structure 220, which have a symmetrical shape. In an embodiment, the first portion 210a and the second portion 210b of the first housing structure 210 may be formed to have different distances from the folding axis A. The widths of the recess 201 are not limited to the illustrated examples. In various embodiments, the recess 201 may have two or more different widths by the shape of the sensor region 213d or the portions of the first housing structure 210 and the second housing structure 220, which have an asymmetrical shape.

In an embodiment, at least portions of the first housing structure 210 and the second housing structure 220 may be formed of a metallic material or a non-metallic material having a selected magnitude of stiffness to support the display 230. In another embodiment, at least portions of the first housing structure 210 and the second housing structure 220 may include an electrically conductive material. If the first housing structure 210 and the second housing structure 220 include an electrically conductive material, the electronic device 200 may transmit and receive radio waves using the portions of the first housing structure 210 and the second housing structure 220, which are made of the electrically conductive material. For example, a processor or a communication module (e.g., the processor 120 or the communication module 190 in FIG. 1) of the electronic device 200 may perform wireless communication using portions of the first housing structure 210 and the second housing structure 220.

In an embodiment, the sensor region 231d may be formed to have a predetermined region adjacent to one corner of the first housing structure 210. However, the disposition, shape, or size of the sensor region 231d is not limited to the illustrated example. For example, in another embodiment, the sensor region 231d may be provided to another corner of the first housing structure 210 or any region between the top and bottom corners. In another embodiment, the sensor region 231d may be disposed in at least a partial region of the second housing structure 220. In another embodiment, the sensor region 231d may be disposed to extend to the first housing structure 210 and the second housing structure 220. In an embodiment, the electronic device 200 may include components exposed to the front surface of the electronic device 200 through the sensor region 213d or through one or more openings provided in the sensor region 231d, and perform various functions through the components. The components disposed in the sensor region 231a may include, for example, at least one of a front camera device (e.g., the camera module 180 in FIG. 1), a receiver (e.g., the audio module 170 in FIG. 1), a proximity sensor, an illuminance sensor, an iris recognition sensor, an ultrasonic sensor (e.g., the sensor module 176 in FIG. 1), or an indicator.

In an embodiment, the first rear cover 240 may be disposed on the second surface 212 of the first housing structure 210 and have a substantially rectangular periphery. In an embodiment, the periphery of the first rear cover 240 may be at least partially surrounded by the first housing structure 210. Similarly, the second rear cover 250 may be disposed on the fourth side 222 of the second housing structure 220, and at least a portion of the periphery thereof may be surrounded by the second housing structure 220.

In the illustrated embodiment, the first rear cover 240 and the second rear cover 250 may have a substantially symmetrical shape with respect to the folding axis A. In another embodiment, the first rear cover 240 and the second rear cover 250 may include various shapes different from each other. In another embodiment, the first rear cover 240 may be integrally formed with the first housing structure 210, and the second rear cover 250 may be integrally formed with the second housing structure 220.

In an embodiment, the first rear cover 240, the second rear cover 250, the first housing structure 210, and the second housing structure 220 may provide a space in which various components (e.g., a printed circuit board, an antenna module, a sensor module, or a battery) of the electronic device 200 may be disposed through a combined structure thereof. In an embodiment, one or more components may be disposed on or visually exposed through the rear surface of the electronic device 200. For example, one or more components or sensors may be visually exposed through the first rear region 241 of the first rear cover 240. In various embodiments, the sensors may include a proximity sensor, a rear camera device, and/or a flash. In another embodiment, at least a portion of the sub-display 252 may be visually exposed through the second rear region 251 of the second rear cover 250.

The display 230 may be disposed in the space formed by the pair of housing structures 210 and 220. For example, the display 230 may be seated on the recess (e.g., the recess 201 in FIG. 2) formed by the pair of housing structures 210 and 220, and may be disposed to occupy substantially most of the front surface of the electronic device 200. For example, the front surface of the electronic device 200 may include the display 230, a partial region (e.g., a periphery region) of the first housing structure 210, and a partial region (e.g., a periphery region) of the second housing structure 220, which are adjacent to the display 230. In an embodiment, the rear surface of the electronic device 200 may include a first rear cover 240, a partial region (e.g., a periphery region) of the first housing structure 210 adjacent to the first rear cover 240, a second rear cover 250, and a partial region (e.g., a periphery region) of the second housing structure 220 adjacent to the second rear cover 250.

In an embodiment, the display 230 may indicate a display in which at least a partial region is able to be deformed into a flat surface or a curved surface. In an embodiment, the display 230 may include a folding region 231c, a first region 231a disposed on one side (e.g., the right region of the folding region 231c) of the folding region 231c, and a second region 231b disposed on the other side thereof (e.g., the left region of the folding region 231c). For example, the first region 231a may be disposed on the first surface 211 of the first housing structure 210, and the second region 231b may be disposed on the third surface 221 of the second housing structure 220. For example, the display 230 may extend from the first surface 211 to the third surface via the hinge structure 264 in FIG. 3, and at least the region (e.g., the folding region 231c) corresponding to the hinge structure may be a flexible region deformable from a flat shape to a curved shape.

In an embodiment, the regional division of the display 230 is exemplary, and the display 230 may be divided into at least one (e.g., four or more or two) regions according to the structure or function thereof. For example, although the folding region 231c may extend along the longitudinal axis (e.g., the Y-axis in FIG. 4) parallel to the folding axis A and the region of the display 230 may be divided by the folding region 231c or the folding axis A in the embodiment shown in FIG. 2, in another embodiment, the region of the display 230 may be divided based on another folding region (e.g., the folding region parallel to the horizontal axis (e.g., the X-axis in FIG. 4)) or another folding region (e.g., the folding axis parallel to the X-axis in FIG. 4). The regional division of the display described above is only a physical division by the pair of housing structures 210 and 220 and the hinge structure (e.g., the hinge structure 264 in FIG. 4), and the display 230 may display a full screen substantially through the pair of housing structures 210 and 220 and the hinge structure (e.g., the hinge structure 264 in FIG. 4).

According to an embodiment, the first region 231a and the second region 231b may have an overall symmetrical shape with respect to the folding region 231c. However, unlike the second region 231b, the first region 231a may include a notch region (e.g., the notch region 233 in FIG. 4) providing the sensor region 231d and have a shape symmetrical to the second region 231b in the remaining regions. For example, the first region 231a and the second region 231b may include a portion having a shape symmetrical to each other and a portion having a shape asymmetrical to each other.

Referring to FIG. 3, the hinge cover 265 may be disposed between the first housing structure 210 and the second housing structure 220, and may be configured to cover internal components (e.g., the hinge structure 264 in FIG. 4). Although the hinge cover 265 is disclosed to be separate from the hinge structure 264 for a brief description, the hinge cover 265 may be a part of the hinge structure 264 and partially form the exterior of the electronic device 200 as mentioned above. In an embodiment, the hinge cover 265 may be covered by portions of the first housing structure 210 and the second housing structure 220 or may be exposed to the outside according to the operation state (unfolded state or folded state) of the electronic device 200.

For example, as shown in FIG. 2, when the electronic device 200 is in the unfolded state, the hinge cover 265 may be covered by the first housing structure 210 and the second housing structure 220 to not be exposed. As another example, as shown in FIG. 3, when the electronic device 200 is in the folded state (e.g., in the completely folded state), the hinge cover 265 may be exposed to the outside between the first housing structure 210 and the second housing structure 220. As another example, in the intermediate state in which the first housing structure 210 and the second housing structure 220 are folded with a certain angle, a portion of the hinge cover 265 may be exposed to the outside of the electronic device 200 between the first housing structure 210 and the second housing structure 220. In this case, the exposed region may be smaller than that in the fully folded state. In an embodiment, the hinge cover 265 may include a curved surface.

Hereinafter, the operation of the first housing structure 210 and the second housing structure 220 and respective regions of the display 230 according to the operation state (e.g., the unfolded state and the folded state) of the electronic device 200 will be described.

In an embodiment, when the electronic device 200 is in the unfolded state (e.g., the state in FIG. 2), the first housing structure 210 and the second housing structure 220 may be disposed to form an angle of 180 degrees such that the first region 231a and the second region 231b of the display face in the same direction, for example, display screens in the direction parallel to each other. In addition, the folding region 231c may form the same plane as the first region 231a and the second region 231b.

In an embodiment, when the electronic device 200 is in the folded state (e.g., the state in FIG. 3), the first housing structure 210 and the second housing structure 220 may be disposed to face each other. For example, when the electronic device 200 is in the folded state (e.g., the state in FIG. 3), the first region 231a and the second region 231b of the display 230 may form a narrow angle (e.g., between 0 degrees and 10 degrees) to face each other. When the electronic device 200 is in the folded state (e.g., the state in FIG. 3), at least a portion of the folding region 231c may form a curved surface having a certain curvature.

In an embodiment, when the electronic device 200 is in the intermediate state, the first housing structure 210 and the second housing structure 220 may be disposed at a certain angle with each other. For example, in the intermediate state, the first region 231a and the second region 231b of the display 230 may form an angle greater than that in the folded state and less than that in the unfolded state. The folding region 231c may be configured as a curved surface in which at least a portion thereof has a certain curvature, and the curvature may be less than that in the folded state.

FIG. 4 is an exploded perspective view of an electronic device 200 according to various embodiments of the disclosure.

Referring to FIG. 4, in an embodiment, the electronic device 200 may include a display 230, a support member assembly 260, at least one printed circuit board 270, a first housing structure 210, a second housing structure 220, a first rear cover 240, and a second rear cover 250. In this document, the display 230 may be referred to as a display module or a display assembly.

The display 230 may include a display panel 231 (e.g., a flexible display panel) and one or more plates 232 or layers on which the display panel 231 is placed. In an embodiment, the plate 232 may be disposed between the display panel 231 and the support member assembly 260. The display panel 231 may be disposed in at least a portion of the surface of the plate 232 (e.g., the surface in the Z direction in FIG. 4). The plate 232 may be formed to have a shape corresponding to the display panel 231. For example, a partial region of the plate 232 may be formed in a shape corresponding to the notch region 233 of the display panel 231.

The support member assembly 260 may include a first support member 261, a second support member 262, a hinge structure 264 disposed between the first support member 261 and the second support member 262, a hinge cover 265 for covering the hinge structure 264 when viewed from the outside, and a wire member 263 (e.g., a flexible printed circuit board (FPCB)) crossing the first support member 261 and the second support member 262.

In an embodiment, the support member assembly 260 may be disposed between the plate 232 and at least one printed circuit board 270. For example, the first support member 261 may be disposed between the first region 231a of the display 230 and the first printed circuit board 271. The second support member 262 may be disposed between the second region 231b of the display 230 and the second printed circuit board 272.

In an embodiment, the wire member 263 and at least a portion of the hinge structure 264 may be disposed inside the support member assembly 260. The wire member 263 may be disposed in the direction (e.g., the X-axis direction) crossing the first support member 261 and the second support member 262. The wire member 263 may be disposed in the direction (e.g., the X-axis direction) perpendicular to the folding axis of the folding region 231c (e.g., the Y-axis or the folding axis A in FIG. 1).

At least one printed circuit board 270, as mentioned above, may include a first printed circuit board 271 disposed on the side of the first support member 261 and a second printed circuit board 272 disposed on the side of the second support member 262. The first printed circuit board 271 and the second printed circuit board 272 may be disposed inside a space formed by the support member assembly 260, the first housing structure 210, the second housing structure 220, the first rear cover 240, and the second rear cover 250. The components for implementing various functions of the electronic device 200, for example, at least one of the components in FIG. 1, may be mounted on the first printed circuit board 271 and the second printed circuit board 272.

In an embodiment, the first housing structure 210 and the second housing structure 220 may be assembled with each other to be coupled to both sides of the support member assembly 260 in the state in which the display 230 is coupled to the support member assembly 260. The first housing structure 210 and the second housing structure 220 may be slidably connected to both sides of the support member assembly 260, for example, to the first support member 261 and the second support member 262, respectively.

In an embodiment, the first housing structure 210 may include a first rotation support surface 214, and the second housing structure 520 may include a second rotation support surface 224 corresponding to the first rotation support surface 214. The first rotation support surface 214 and the second rotation support surface 224 may include curved surfaces corresponding to the curved surface included in the hinge cover 265.

In an embodiment, when the electronic device 200 is in the unfolded state (e.g., the state in FIG. 2), the first rotation support surface 214 and the second rotation support surface 224 may cover the hinge cover 265 so that the hinge cover 265 may not be exposed to the rear surface of the electronic device 200 or may be minimally exposed thereto. In an embodiment, when the electronic device 200 is in the folded state (e.g., the state in FIG. 3), the first rotation support surface 214 and the second rotation support surface 224 may rotate along the curved surface included in the hinge cover 265, thereby maximally exposing the hinge cover 265 to the rear surface of the electronic device 200.

In the above detailed description, the first housing structure 210, the second housing structure 220, the first side member 213, the second side member 223, or the like are used to distinguish elements using ordinal numbers, but it is noted that the disclosure is not limited to the described ordinal numbers. For example, although the sensor region 231d is illustrated as being formed in the first housing structure 210, the sensor region 213d may be formed in the second housing structure 220 or formed in both the first and second housing structures 210 and 220. In another embodiment, although the configuration is exemplified in which the first rear region 241 is disposed on the first rear cover 240 and in which the sub-display 251 is disposed on the second rear cover 250, all of the first rear region 241 for disposing sensors and the like and the sub-display 251 for outputting screens may be disposed on any one of the first rear cover 240 and the second rear cover 250.

According to various embodiments of the disclosure, the antenna device may be disposed in the first housing structure 210 or the second housing structure 220. In the following detailed description, the antenna device according to various embodiments of the disclosure will be described by way of example with the configuration in which the antenna device is generally disposed in the second housing structure 220. However, as mentioned above, the disclosure is not limited thereto, and the electronic device 200 according to various embodiments of the disclosure may include an antenna device disposed in the first housing structure 210.

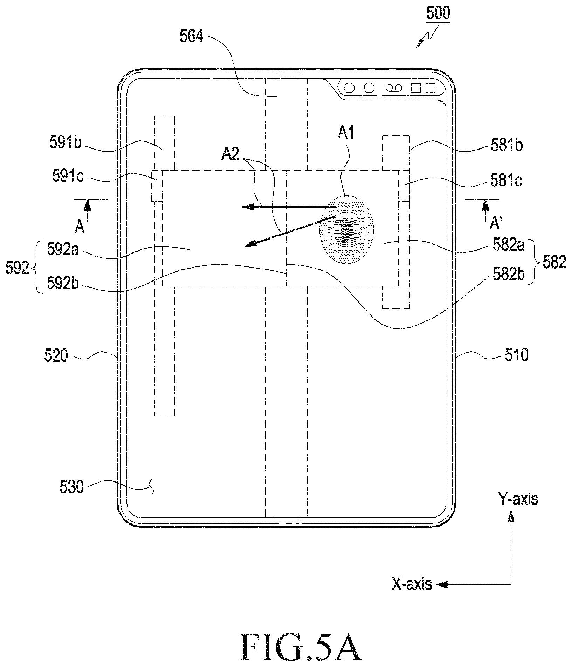

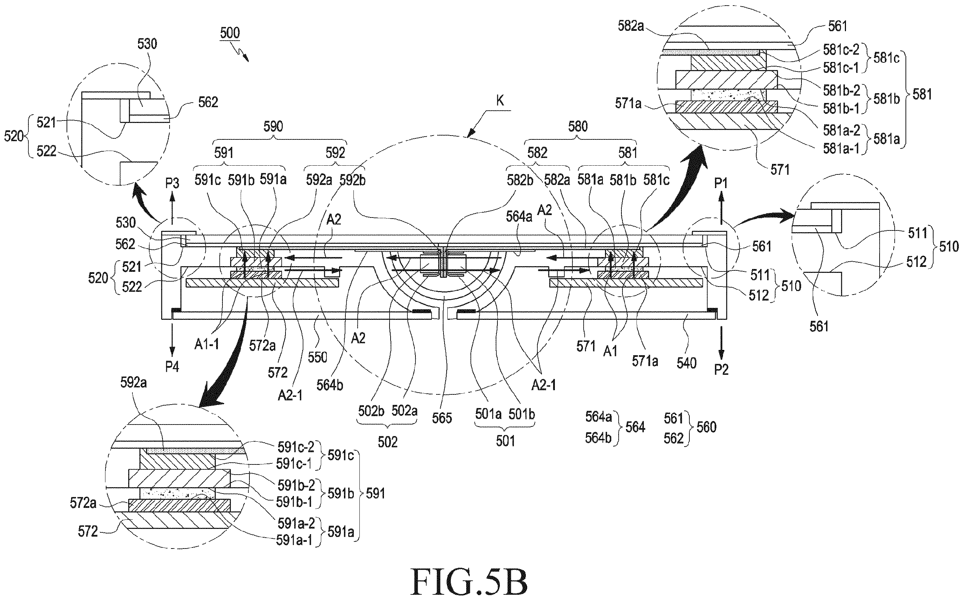

FIG. 5A is a diagram illustrating heat A1 distribution and heat transfer paths A2 of some elements included in a foldable electronic device 500 (e.g., the electronic device 200 in FIG. 2) when the foldable electronic device 500 is in an unfolded status according to various embodiments of the disclosure, and FIG. 5B is a cross-sectional view taken along line A-A' in FIG. 5A, which is a side cross-sectional view illustrating the configuration of heat transfer structures 580 and 590.

Referring to FIGS. 5A and 5B, according to various embodiments, the foldable electronic device 500 may include an in-folding type or an out-folding type. The in-folding type may indicate the state in which a flexible display 530 (e.g., the display 230 in FIG. 2) included in the foldable electronic device 500 is not exposed to the outside in a fully folded status. The out-folding type may indicate the state in which the flexible display 530 (e.g., the display 230 in FIG. 2) is exposed to the outside in the fully folded status.

According to various embodiments, the foldable electronic device 500 may include a first housing structure 510, a second housing structure 520, and a hinge structure 564. The foldable electronic device 500 may be configured such that the second housing structure 520 is rotatable with respect to the first housing structure 510. According to the rotation operation, a folded status in which the first housing structure 510 and the second housing structure 520 face each other, an unfolded status in which the first housing structure 510 and the second housing structure 520 are disposed parallel to each other, or an intermediate status maintaining a specified angle may be included. FIGS. 5A and 5B show the unfolded status (e.g., a flat state).

According to various embodiments, the first housing structure 510 may include a first surface 511 facing in a first direction P1 and a second surface 512 facing in a second direction P2 opposite the first direction P1. The second housing structure 520 may include a third surface 521 facing in a third direction P3 and a fourth surface 522 facing in a fourth direction P4 opposite the third direction P3. According to an embodiment, the first direction P1 and the third direction P3 may be disposed in the direction facing each other from the same direction by rotation of the hinge structure 564. As another example, the second direction P2 and the fourth direction P4 may be disposed in opposite directions from the same direction by the rotation of the hinge structure 564. For example, in the folded state of the first housing structure 510 and the second housing structure 520, the first surface 511 may face the third surface 521, and, in the unfolded state thereof, the third direction P3 may be the same as the first direction P1. As another example, in the folded state of the first housing structure 510 and the second housing structure 520, the second surface 512 may face in the opposite direction of the fourth surface 522, and in the unfolded state thereof, the fourth direction P4 may be the same as the second direction P2.

According to various embodiments, the flexible display 530 may be disposed to extend from the first surface 511 to the third surface 521. According to an embodiment, the flexible display 530 may include a display panel, and a support member assembly 560 supporting the flexible display 530 under the flexible display 530 may be included.

According to an embodiment, the flexible display 530 may be made of a material that at least partially transmits radio waves or magnetic fields. The flexible display 530 may be equipped with a display panel and/or a touch panel. For example, the flexible display 530 may be utilized as an output device for outputting screens and as an input device equipped with a touch screen function. The display panel may include, for example, an active matrix organic light-emitting diode, and the display panel may include a display element layer including at least one pixel and a TFT layer connected to the display element layer.

According to various embodiments, the support member assembly 560 may be disposed on a rear surface and/or a side surface of the display panel to surround at least a portion of the display panel to support the same. The support member assembly 560 may include one or more plates on which the flexible display is placed, and may be, for example, a SUS plate.

According to an embodiment, the support member assembly 560 may be disposed between the flexible display 530 and the first rear cover 540/the second rear cover 550. For example, the support member assembly 560 may include a first support member 561 and a second support member 562, which are disposed to be spaced apart from each other. The first support member 561 may be disposed to face the first surface 511 of the first housing structure 510, and the second support member 562 may be disposed to face the third surface 521 of the second housing structure 520. The first support member 561 and the second support member 562 may be disposed such that regions corresponding to the region (folding region) where the flexible display 530 is folded are spaced apart a specific distance from each other.

Referring to FIGS. 5A and 5B mentioned above, the heat transfer structures 580 and 590 of the foldable electronic device 500 may include a first heat transfer structure 580 or a second heat transfer structure 590, the first heat transfer structure 580 may be disposed in at least a portion of the first housing structure 510 and at least a portion of the hinge structure 564, and the second heat transfer structure 590 may be disposed in at least a portion of the second housing structure 520 and at least a portion of the hinge structure 564. The first heat transfer structure 580 and the second heat transfer structure 590 may be disposed in the first housing structure 510, the second housing structure 520 and the hinge structure 564, thereby effectively transferring (A2) the high-temperature heat A1 concentrated in the first housing structure 510 to the second housing structure 520 in a lower-temperature state to be dispersed.

Referring to FIGS. 5A and 5B described above, in case of the first and second printed circuit boards 571 and 572 (PCBs) on which at least one high-performance first or second element 571a or 571b such as an application processor (AP), a memory, or communication chip is mounted, the high-temperature heat A1 generated by the at least one first element 571a during the operation of the foldable electronic device 500 may be concentrated in a partial region (e.g., a hotspot region on one side of the first printed circuit board 571). Alternatively, the high-temperature heat A1-1 generated by the at least one second element 571b may be concentrated in a partial region (e.g., a hotspot region on one side of the second printed circuit board 572). For example, in the foldable electronic device 500, a processor (e.g., an AP) and an antenna modem (e.g., a 5G antenna modem) may emit the maximum heat, among the various one or more first and second elements 571a and 572a mounted on the first and second printed circuit boards 571 and 572 (PCBs).

Accordingly, the heat transfer structures 580 and 590 of the foldable electronic device 500 may effectively transfer (A2 and A2-1) the high-temperature heat A1 and A1-1 concentrated in the hotspot region to a lower-temperature side to be dispersed.

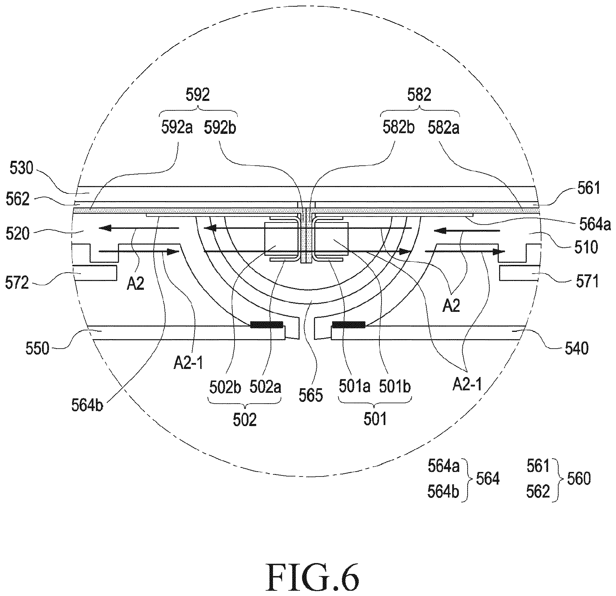

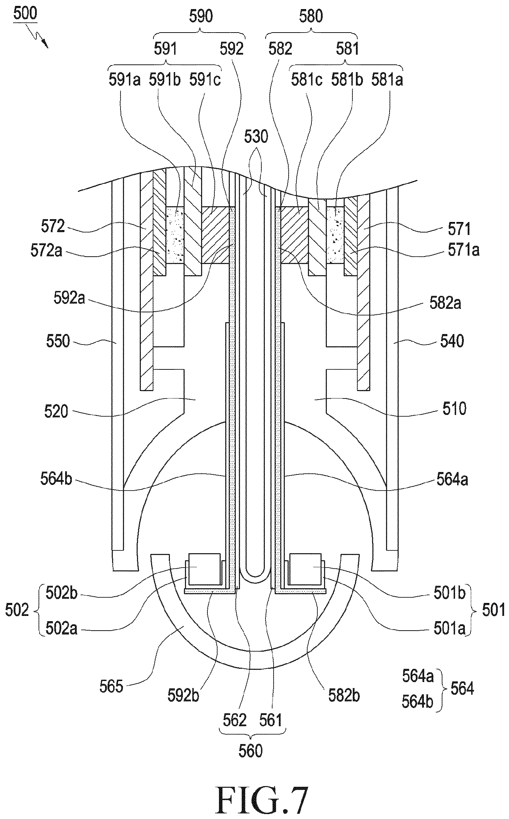

Hereinafter, various heat transfer structures 580 and 590 for transferring the high-temperature heat A1 (e.g., the heat A1-1 in FIG. 5B) generated in the first and second elements 571a and 572a (e.g., an AP or a 5G antenna modem) from the first housing structure 510 or the second housing structure 520 in a high-temperature state due to the heat to the first housing structure 510 or the second housing structure 520 in a lower- temperature state will be described in detail with reference to FIGS. 6 and 7.

FIG. 6 is an enlarged cross-sectional view of the portion K in FIG. 5B, which is a view illustrating the configuration of heat transfer structures 580 and 590 when a foldable electronic device 500 is in an unfolded state according to various embodiments of the disclosure, and FIG. 7 is an enlarged cross-sectional view of the portion K in FIG. 5B, which is a view illustrating the configuration of heat transfer structures 580 and 590 when a foldable electronic device 500 is in a folded state according to various embodiments of the disclosure.

Referring to FIGS. 6 and 7, according to various embodiments, the heat transfer structure of the foldable electronic device 500 may include a hinge cover 565 that covers a hinge structure 564, first and second housing structures 510 and 520, first and second fastening members 501 and 502, first and second printed circuit boards 571 and 572, and first and second heat transfer structures 580 and 590. For example, the first and second housing structures 510 and 520 may be connected to the hinge structure 564 and rotate about the hinge structure 564 to be disposed in an unfolded state or folded state. The first and second fastening members 501 and 502 may be mounted to the hinge structure 564 and maintain the unfolded state or folded state of the first and second housing structures 510 and 520 according to attachment and detachment thereof. For example, the first and second fastening portions 501 and 502 may include first and second seat portions 501a and 502a and first and second magnets 501b and 502b. The first seat portion 501a may be connected to a first hinge member 564a provided in the hinge structure 564, and the first magnet 501b may be seated on the first seat portion 501a. The second seat portion 502a may be connected to a second hinge member 564b provided in the hinge structure 564, and the second magnet 502b may be seated on the second seat portion 502a.

According to various embodiments, in the unfolded state of the first and second housing structures 510 and 520, the first and second fastening members 501 and 502 may be attached by the magnetic force of the first and second magnets 501b and 502b, and at this time, the first and second housing structures 510 and 520 may be attached by the magnetic force of the first and second magnets 501b and 502b to maintain the unfolded state thereof. In the folded state of the first and second housing structures 510 and 520, the first and second fastening members 501 and 502 may be separated from each other and, at the same time, the first and second magnets 501b and 502b may also be separated. At this time, since the magnetic force does not affect the first and second housing structures 510 and 520 due to separation of the first and second magnets 501b and 502b, the first and second housing structures 510 and 520 may be separated to maintain the folded state.

At least one first element 571a may be mounted on at least a partial surface of the first printed circuit board 571, and at least one second element 572a may be mounted on at least a partial surface of the second printed circuit board 572. The first heat transfer structure 580 may be disposed in at least a portion of the first housing structure 510 and at least a portion of the hinge structure 564, and the second heat transfer structure 590 may be disposed in at least a portion of the second housing structure 520 and at least a portion of the hinge structure 564.

According to various embodiments, the first heat transfer structure 580 may include a first heat transfer region 581 and a first heat transfer member 582. For example, the first heat transfer region 581 may include a first heat transfer portion 581a, a first cooling member 581b, and a second heat transfer portion 581c.

Referring to FIG. 5B mentioned above, the first heat transfer portion 581a may form a first surface 581a-1 and a second surface 581a-2, the surface 581a-1 of the first heat transfer portion 581a may face at least a partial surface of the at least one first element 571a, and the second surface 581a-2 opposite the first surface 581a-1 of the first heat transfer portion 581a may face a first surface 581b-1 of the first cooling member 581b, which will be described later. The first cooling member 581b may form a first surface 581b-1 and a second surface 581b-1, the first surface 581b-1 of the first cooling member 581b may face the second surface 581a-2 of the first heat transfer portion 581a, and the second surface 581b-2 opposite the first surface 581b-1 of the first cooling member 581b may face a first surface 581c-1 of the second heat transfer portion 581c, which will be described later. The second heat transfer portion 581c may form a first surface 581c-1 and a second surface 581c-1, the first surface 581c-1 of the second heat transfer portion 581c may face the second surface 581b-2 of the cooling member 581b, and the second surface 581c-2 opposite the first surface 581c-1 of the second heat transfer portion 581c may face at least a partial surface of a first surface 582a of the first heat transfer member 582, which will be described later. At least a partial surface of the second surface 582b opposite the first surface of the first heat transfer member 582 may face at least a partial surface of the first fastening member 501.

The second heat transfer structure 590 may include a second heat transfer region 591 and a second heat transfer member 592. For example, the second heat transfer region 591 may include a third heat transfer portion 591a, a second cooling member 591b, and a fourth heat transfer portion 591c.

Referring to FIG. 5B mentioned above, the third heat transfer portion 591a may form a first surface 591a-1 and a second surface 591a-2, the first surface 591a-1 of the third heat transfer portion 591a may face at least a partial surface of the at least one second element 572a, and the second surface 591a-2 opposite the first surface 591a-1 of the third heat transfer portion 591a may face a first surface 591b-1 of the second cooling member 591b, which will be described later. The second cooling member 591b may form a first surface 591b-1 and a second surface 591b-2, the first surface 591b-1 of the second cooling member 591b may face the second surface 591a-2 of the third heat transfer portion 591a, and the second surface 591b-2 opposite the first surface 591b-1 of the second cooling member 591b may face a first surface 591c-1 of the fourth heat transfer portion 591c, which will be described later. The fourth heat transfer portion 591c may form a first surface 591c-1 and a second surface 591c-2, the first surface 591c-1 of the fourth heat transfer portion 591c may face the second surface 591b-2 of the second cooling member 591b, and the second surface 591c-2 opposite the first surface 591c-1 of the fourth heat transfer portion 591c may face at least a partial surface of a first surface 592a of the second heat transfer member 592, which will be described later. At least a partial surface of the second surface 592b opposite the first surface 592a of the second heat transfer member 592 may face at least a partial surface of the second fastening member 502.

In this state, when the first and second housing structures 510 and 520 are rotated and unfolded by the hinge structure 564, the first magnet 501b of the first fastening member 501 and the second magnets 502b of the second fastening member 502 may be attached to each other by magnetic force so that the first and second housing structures 510 and 520 may be in the unfolded state. At this time, at least partial surfaces of the second surfaces 582b and 592b of the first and second heat transfer members 582 and 592 disposed on at least partial surfaces of the first and second fastening members 501 and 502 may face each other. Accordingly, the first and second magnets 501b and 502b may attach the second surfaces 582b and 592b of the first and second heat transfer members 582 and 592 by magnetic force to come into contact with each other, so that the first and second magnets 501b and 502b may provide a stronger contact force between the second surfaces 582b and 592b of the first and second heat transfer members 582 and 592, thereby reducing the contact heat resistance between the first and second heat transfer members 582 and 592 and further improving the heat transfer function of the first and second heat transfer members 582 and 592.

In this state, referring to FIG. 5B mentioned above, heat A1 may be generated in the at least one first element 571a during the signal processing operation, and the generated heat A1 may be transferred to the first heat transfer portion 581a of the first heat transfer region 581, and the heat A1 transferred to the first heat transfer portion 581a may be transferred to the first cooling member 581b. The first cooling member 581b may primarily cool the transferred heat A1. At this time, the heat A1 that has not yet been cooled by the first cooling member 581b may be transferred to the second heat transfer portion 581c, the heat A1 transferred to the second heat transfer portion 581c may be transferred to the first heat transfer member 582, and the heat A1 transferred to the first heat transfer member 582 may be transferred to the second heat transfer member 592. For example, since the second surfaces 582b and 592b of the first and second heat transfer members 582 and 592 face each other by the first and second fastening portions 501 and 502, the heat A1 transferred to the first heat transfer member 582 may be transferred to the second heat transfer member 592, and at this time, the heat A1 transferred to the second heat transfer member 592 may be diffused or dispersed to the low-temperature region of the second housing structure 520. For example, the high-temperature heat A1 generated in the at least one first element 571a may be transferred to the second heat transfer member 592 disposed in the second housing structure 520 by passing through (A2) the first heat transfer member 582 disposed in the first housing structure 510.

Accordingly, the high-temperature heat A1 generated in the at least one first element 571a may be transferred from the first housing structure 510 to the second housing structure 520 through the first and second heat transfer members 582 and 592, so that the high-temperature heat A1 generated in the first element 571a may rapidly diffuse or disperse from the first housing structure 510 in a high-temperature state to the second housing structure 520 in a low-temperature state. As a result, it is possible to prevent the high-temperature heat A1 from being concentrated only in the first housing structure 510. Accordingly, the high-temperature heat A1 may be rapidly cooled, thereby enabling a stable operating environment for the at least one first or second element 571a or 571b.

As another example, referring to FIG. 5B mentioned above, the second heat transfer member 592 may transfer, to the first heat transfer member 582, the high-temperature heat A1-1 of the at least one second element 572a transferred to the second heat transfer region 591 so as to rapidly diffuse or disperse the high-temperature heat A1-1 from the second housing structure 520 to the first housing structure 510, thereby preventing the high-temperature heat A1-1 from being concentrated only in the second housing structure 520. For example, the heat A1-1 generated during the signal processing operation of the at least one second element 572a may be transferred to a third heat transfer portion 591a of the second heat transfer region 591, and the heat A1 transferred to the third heat transfer portion 591a may be transferred to the second cooling member 591b. The second cooling member 591b may primarily cool the transferred heat A1-1. At this time, the heat A1-1 that has not yet been cooled by the second cooling member 591b may be transferred to the fourth heat transfer portion 591c, the heat A1-1 transferred to the fourth heat transfer portion 591c may be transferred to the second heat transfer member 592, and the heat A1-1 transferred to the second heat transfer member 592 may be transferred to the first heat transfer member 582. At this time, the heat A1-1 may flow (A2-1) from the second housing structure 520 to the first housing structure 510 through the first and second heat transfer members 582 and 592.

Accordingly, by preventing the heat A1 or A1-1 transferred to the first heat transfer member 582 or the second heat transfer member 592 from being concentrated in any one of the first housing structure 510 or the second housing structure 520, it is possible to effectively cool the heat A1 or A1-1 transferred to the first housing structure 510 or the second housing structure 520 and to effectively transfer the heat A1 and A1-1 generated by the first and second elements 571a and 572a to the housing having a relatively low temperature. Accordingly, the temperature of the at least one first or second element 571a or 572a or the temperature of the space in which the first and second elements 571a and 572a are disposed in the foldable electronic device 500 may be lowered.

According to various embodiments, the first and second cooling members 581b and 591b may include at least one of a heat pipe or a heat chamber. The first and second cooling members 581b and 591b may be configured as at least one of a heat pipe or a heat chamber, thereby further improving the cooling function of the first and second cooling members 581b and 591b. In the embodiment, although the first and second cooling members 581b and 591b are described as examples of a heat pipe or a heat chamber, they are not limited thereto. For example, any configuration capable of transferring the heat A1 and A1-1 transferred from the first and third heat transfer portions 581a and 591a to the second and fourth heat transfer portions 581c and 591c may be variously applied to the first and second cooling members 581b and 591b.

According to various embodiments, the first and second heat transfer members 582 and 592 may include at least one of a heat pipe, a heat chamber, or a graphite or copper sheet. The first and second heat transfer members 582 and 592 may be configured as at least one of a heat pipe, a heat chamber, or a graphite or copper sheet, thereby further improving the heat transfer function of the first and second heat transfer members 582 and 592. In the embodiment, although the first and second heat transfer members 582 and 592 are described as examples of a heat pipe, a heat chamber, or a graphite or copper sheet, they are not limited thereto. For example, any configuration capable of transferring the heat A1 and A1-1 may be variously applied to the first and second heat transfer members 582 and 592.

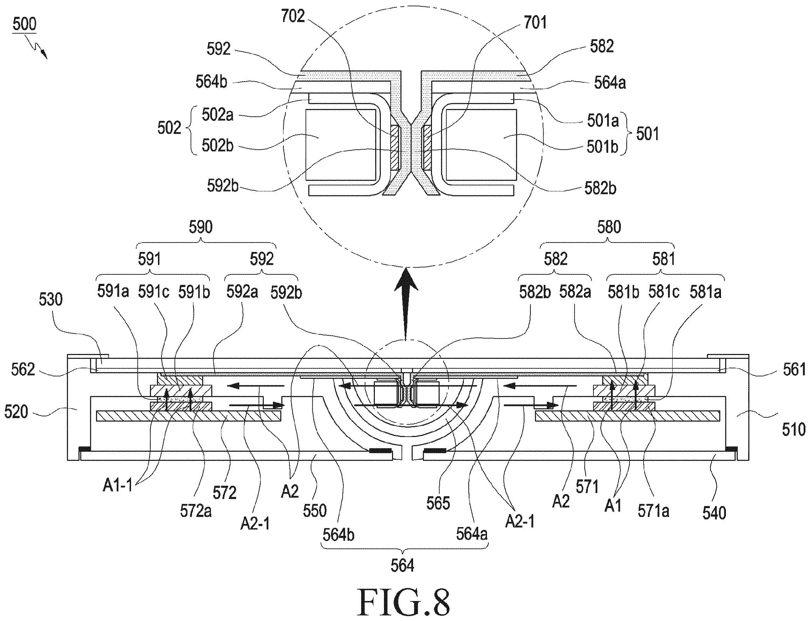

FIG. 8 is a side cross-sectional view illustrating another embodiment of heat transfer structures 580 and 590 when a foldable electronic device 500 is in an unfolded state according to various embodiments of the disclosure.

Referring to FIG. 8, a foldable electronic device 500 including heat transfer structures 580 and 590 according to various embodiments may include a hinge cover 565 for covering the hinge structure 564, first and second housing structures 510 and 520, first and second fastening members 501 and 502, a first printed circuit board 571 on which at least one first element 571a is mounted, a second printed circuit board 572 on which at least one second element 572a is mounted, and first and second heat transfer structures 580 and 590. For example, the first heat transfer structure 580 may be disposed in at least a portion of the first housing structure 510 and in at least a portion of the hinge structure 564, and the second heat transfer structure 590 may be disposed in at least a portion of the second housing structure 520 and in at least a portion of the hinge structure 564. The first heat transfer structure 580 may include the first heat transfer region 581 and the first heat transfer member 582, and the second heat transfer structure 590 may include the second heat transfer region 591 and the second heat transfer member 592.

At least one of the elements of the foldable electronic device 500 including the heat transfer structures 580 and 590 may be the same as or similar to at least one of the elements of the foldable electronic device including the heat transfer structures 580 and 590 in FIG. 5A or 5B, so duplicate descriptions thereof will be omitted below.

According to various embodiments, the first and second fastening members 501 and 502 may maintain the folded state or unfolded state of the first and second housing structures 510 and 520 according to attachment and detachment thereof. For example, when the first and second housing structures 510 and 520 are rotated to be unfolded by the hinge structure 564, a first magnet 501b provided in the first fastening member 501 and a second magnet 502b provided in the second fastening member 502 may be attached to each other by magnetic force so that the first and second housing structures 510 and 520 may be in the unfolded state. The first magnet 501b may be seated on a first seat portion 501a connected to the first hinge member 564a of the hinge structure 564, and the second magnet 502b may be seated on a second seat portion 502a connected to the second hinge member 564b of the hinge structure 564.

At least a partial surface of the first seat portion 501a may face the end of the first heat transfer member 582, and at least a partial surface of the second seat portion 502a may face the end of the second heat transfer member 592.

A first buffer 701 may be provided between the first seat portion 501a and the first heat transfer member 582, and a second buffer 702 may be provided between the second seat portion 502a and the second heat transfer member 592. For example, when the first and second housing structures 510 and 520 are unfolded, the outer surface of the end 582b of the first heat transfer member 582 and the outer surface of the end 592b of the second heat transfer member 592 may come into contact with each other to face each other. At this time, if the first heat transfer member 582 and the second heat transfer member 592 come into contact with each other, the contact surface of the first heat transfer member 582 and the second heat transfer member 592 may be impacted.

According to various embodiments, the first and second buffers 701 and 721 may absorb and relieve a contact impact transmitted to the outer surfaces of the ends of the first and second heat transfer members 582 and 592. Accordingly, the first and second heat transfer members 582 and 592 may prevent damage due to contact of the first and second heat transfer members 582 and 592.

According to an embodiment, the first and second buffers 701 and 721 may cause the outer surfaces of the ends of the first and second heat transfer members 582 and 592 to come into closer contact with each other, and the first and second heat transfer members 582 and 592 in close contact may further improve the efficiency of flow A2 and A2-1 of the heat A1 and A1-1 and transfer of the heat A1 and A1-1. For example, the outer surfaces of the ends of the first and second heat transfer members 582 and 592 may come into strong contact with each other by the first and second buffers 701 and 721 so that the contact heat resistance between the first and second heat transfer members 582 and 592 may be reduced, and thus the first and second heat transfer members 582 and 592 may further improve the heat transfer function.

According to various embodiments, the first and second buffers 701 and 721 may include at least one of, for example, a sponge, a foam tape, rubber, or silicone. In addition to the materials disclosed above, any material capable of absorbing a contact or close contact impact may be variously applied to the first and second buffers 701 and 721. As described above, the first and second buffers 701 and 721 may include at least one of sponge, foam tape, rubber, and silicone, thereby further improving the close contact between the first and second heat transfer members 582 and 592 and preventing damage caused by contact.

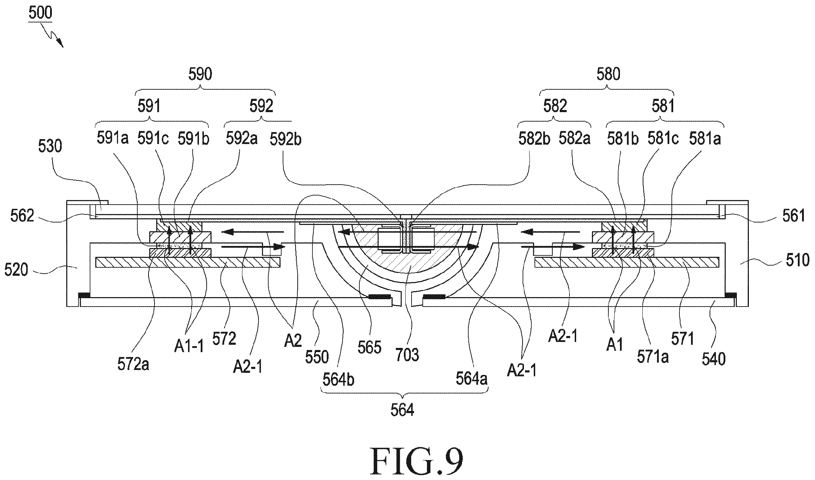

FIG. 9 is a side cross-sectional view illustrating another embodiment of heat transfer structures 580 and 590 when a foldable electronic device 500 is in an unfolded state according to various embodiments of the disclosure.

Referring to FIG. 9, a foldable electronic device 500 including heat transfer structures 580 and 590 according to various embodiments may include a hinge cover 565 for covering a hinge structure 564, first and second housing structures 510 and 520, first and second fastening members 501 and 502, a first printed circuit board 571 on which at least one first element 571a is mounted, a second printed circuit board 572 on which at least one second element 572a is mounted, and first and second heat transfer structures 580 and 590. For example, the first heat transfer structure 580 may be disposed in at least a portion of the first housing structure 510 and in at least a portion of the hinge structure 564, and the second heat transfer structure 590 may be disposed in at least a portion of the second housing structure 520 and in at least a portion of the hinge structure 564. The first heat transfer structure 580 may include the first heat transfer region 581 and the first heat transfer member 582, and the second heat transfer structure 590 may include the second heat transfer region 591 and the second heat transfer member 592.

At least one of the elements of the foldable electronic device 500 including the heat transfer structures 580 and 590 may be the same as or similar to at least one of the elements of the foldable electronic device including the heat transfer structures 580 and 590 in FIG. 5A or 5B, so duplicate descriptions thereof will be omitted below.

According to various embodiments, the first and second fastening members 501 and 502 may maintain the folded state or unfolded state of the first and second housing structures 510 and 520 according to attachment and detachment thereof. For example, when the first and second housing structures 510 and 520 are rotated to be unfolded by the hinge structure 564, a first magnet 501b provided in the first fastening member 501 and a second magnet 502b provided in the second fastening member 502 may be attached to each other by magnetic force so that the first and second housing structures 510 and 520 may be in the unfolded state.

A phase change material 703 that is in contact with the first and second heat transfer members 582 and 592 and transfers the heat A1 of the first heat transfer member 582 to the second heat transfer member 592 or transfers the heat A1-1 of the second heat transfer member 592 to the first heat transfer member 582 may be included in the hinge cover 565.

Here, the phase change material 703 may exist in several states or phases, and the most well-known are solid, liquid, and gaseous states. When two objects having different temperatures come into contact with each other, energy, that is, heat A1 and A1-1 flows (A2 and A2-1) from the high-temperature object to the low-temperature object. Energy may be transferred in this way so that the temperature of the low-temperature object increases and the temperature of the high-temperature object is reduced. Some substances may absorb heat A1 and A1-1 while changing in the state (or phase) thereof from solid to liquid (melting), from solid to gas (sublimation), from liquid to gas (vaporization), or from solid to another solid (usually called a crystalline transition) without a change in temperature.

As shown in FIG. 9 described above, the phase change material 703 may be coupled to the hinge cover 565 and come into contact with at least portions of the first and second heat transfer members 582 and 592 disposed inside the hinge cover 565 so that the phase change material 703 may rapidly absorb the heat A1 transferred to the first heat transfer member 582, and the absorbed heat A1 may be transferred (A2) from the first heat transfer member 582 to the second heat transfer member 592. Accordingly, the phase change material 703 may efficiently transmit the heat A1 generated in the at least one first element 571a from the first housing structure 510 having a high temperature to the second housing structure 920 having a relatively low temperature. As another example, the phase change material 703 may rapidly absorb the heat A1-1 transferred to the second heat transfer member 592, and the phase change material 703 may transfer (A2-1) the absorbed heat A1-1 from the second heat transfer member 592 to the first heat transfer member 582. As described above, the phase change material 703 may efficiently transfer the heat A1-1 generated in the at least one second element 572a from the second housing structure 520 having a high temperature to the first housing structure 510 having a relatively low temperature.

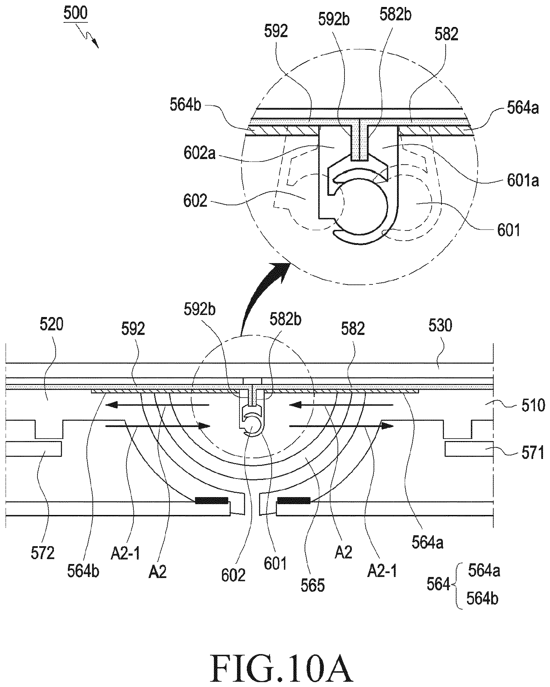

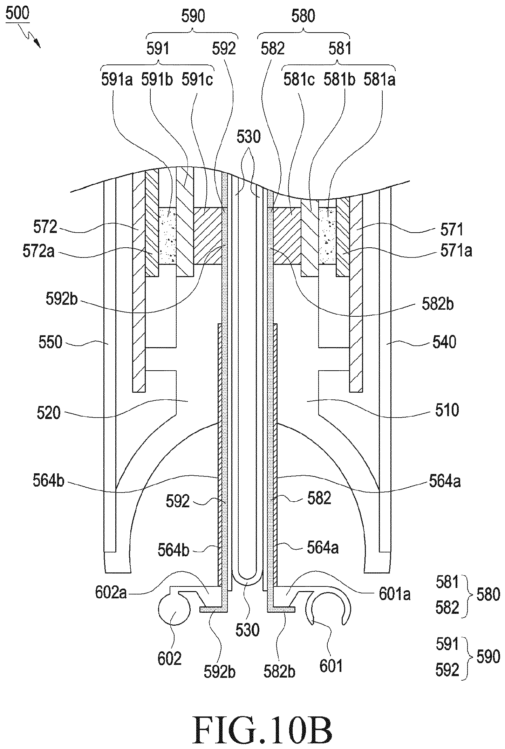

FIG. 10A is a side cross-sectional view illustrating another embodiment of a first fastening member (e.g., the first fastening member 501 in FIG. 5B) and a second fastening member (e.g., the second fastening member 502 in FIG. 5B) when a foldable electronic device 500 is in an unfolded status according to various embodiments of the disclosure, and FIG. 10B is a side cross-sectional view illustrating another embodiment of first and second fastening members 501 and 502 when a foldable electronic device 500 is in a folded status according to various embodiments of the disclosure.

Referring to FIGS. 10A and 10B, according to various embodiments, heat transfer structures 580 and 590 of the foldable electronic device 500 may include a hinge cover 565 for covering a hinge structure 564, first and second housing structures 510 and 520, first and second fastening members (e.g., the first and second fastening members 501 and 502 in FIG. 5B), first and second printed circuit boards 571 and 572, and first and second heat transfer structures 580 and 590. For example, the first and second housing structures 510 and 520 may be connected to the hinge structure 564 and rotate about the hinge structure 564 to be disposed in an unfolded status or folded status.

At least one of the elements of the foldable electronic device 500 including the heat transfer structures 580 and 590 may be the same as or similar to at least one of the elements of the foldable electronic device including the heat transfer structures 580 and 590 in FIG. 5A or 5B, so duplicate descriptions thereof will be omitted below.

According to various embodiments, the first fastening member 501 may be configured as a first fastening portion 601, and the second fastening member 502 may be configured as a second fastening portion 602. The first and second fastening portions 601 and 602 may be mounted on the hinge structure 564, and maintain the unfolded status or folded status of the first and second housing structures 510 and 520 according to attachment and detachment to and from each other. For example, the first fastening portion 601 may be configured as an attachment/detachment groove, and the second fastening portion 602 may be configured as an attachment/detachment protrusion. The first fastening portion 601 may be connected to a first hinge member 564a provided in the hinge structure 564, and may be coupled to and separated from the second fastening portion 602, which will be described later, in the unfolded state or folded state of the first and second housing structures 510 and 520. The second fastening portion 602 may be connected to a second hinge structure 564b included in the hinge structure 564, and the second fastening portion 602 may be coupled to or separated from the first fastening portion 601 in the unfolded state or folded state of the first and second housing structures 510 and 520.

According to various embodiments, the second fastening portion 602 configured as the attachment/detachment protrusion may be coupled to the first fastening portion 601 configured as the attachment/detachment groove in the unfolded status of the first and second housing structures 510 and 520. At this time, the first and second housing structures 510 and 520 may maintain the unfolded status.

At least a portion of the first fastening portion 601 configured as the attachment/detachment groove may be connected to the end of the first heat transfer member 582 of the first heat transfer structure 580, and at least a portion of the second fastening portion 602 configured as the attachment/detachment protrusion may be connected to the end of the second heat transfer member 592 of the second heat transfer structure 590.

According to various embodiments, the first fastening portion 601 and the second fastening portion 602 may be made of a material that transfers heat (e.g., the heat A1 and A1-1 in FIG. 5B). For example, the first fastening portion 601 and the second fastening portion 602 may be made of a heat transfer metal material. In the embodiment, in addition to the heat transfer metal material, any material capable of transmitting heat may be applied to the material of the first fastening portion 601 and the second fastening portion 602. For example, the first fastening portion 601 and the second fastening portion 602 may transfer the heat A1 and A1-1 to each other in the state in which they are coupled.

The heat of the at least one first element 571a (e.g., the heat A1 in FIG. 5A) transferred to the first heat transfer member 582 may flow (e.g., the flow A2 in FIG. 5A) to the second fastening portion 602 by passing through the first fastening portion 601 in the state in which the second fastening portion 602 configured as the attachment/detachment protrusion is coupled to the first fastening portion 601 configured as the attachment/detachment groove. At this time, the heat (e.g., the heat A1 in FIG. 5A) may be transferred from the first fastening portion 601 to the second fastening portion 602. The second fastening portion 602 may transfer the heat (e.g., the heat A1 in FIG. 5A) to the second heat transfer member 592. As another example, the heat of the at least one second element 572a (e.g., the heat A1-1 in FIG. 5B) transferred to the second heat transfer member 592 may flow (e.g., the flow A2-1 in FIG. 5B) to the first fastening portion 601 by passing through the second fastening portion 602. At this time, the heat (e.g., the heat A1-1 in FIG. 5B) may be transferred from the second fastening portion 602 to the first fastening portion 601. The first fastening portion 601 may transfer the heat (e.g., the heat A1-1 in FIG. 5B) to the first heat transfer member 582.

In the folded status of the first and second housing structures 510 and 520, the second fastening portion 602 configured as the attachment/detachment protrusion may escape from the first fastening portion 601 configured as the attachment/detachment groove to be separated therefrom. The first and second housing structures 510 and 520 may maintain the folded state while the first fastening portion 601 and the second fastening portion 602 are separated. At this time, since the first fastening portion 601 and the second fastening portion 602 are separated from each other, the heat A1 transferred to the first heat transfer member 582 may not be transferred to the second heat transfer member 592. Likewise, the heat A1-1 transferred to the second heat transfer member 592 may not be transferred to the first heat transfer member 582.

As described above, in the unfolded state or folded state of the first and second housing structures 510 and 520, the second fastening portion 602 connected to the second heat transfer member 592 may be coupled to or separated from the first fastening portion 601 connected to the first heat transfer member 582. When the second fastening portion 602 is coupled to the first fastening portion 601, the high-temperature heat generated in the at least one first element 571a (e.g., the heat A1 in FIG. 5) transferred to the first heat transfer member 582 may be easily transferred to the second heat transfer member 592.

Accordingly, the high-temperature heat (e.g., the heat A1 in FIG. 5) may be transferred more rapidly from the first housing structure 510 in a high-temperature state to the second housing structure 520 in a low-temperature state, thereby improving the cooling efficiency with respect to the heat (e.g., the heat A1 in FIG. 5).

As another example, when the second fastening portion 602 is coupled to the first fastening portion 601, the high-temperature heat generated in the at least one second element 572a (e.g., the heat A1-1 in FIG. 5) transferred to the second heat transfer member 592 may be easily transferred to the first heat transfer member 582, and thus the high-temperature heat (e.g., the heat A1-1 in FIG. 5) may be transferred more rapidly from the second housing structure 520 in a high-temperature state to the first housing structure 510 in a low-temperature state, thereby improving the cooling efficiency with respect to the heat (e.g., the heat A1-1 in FIG. 5).

As another example, when the first and second housing structures 510 and 520 are rotated and unfolded by the hinge structure 564, the second fastening portion 602 configured as the attachment/detachment protrusion may be coupled to the first fastening portion 601 configured as the attachment/detachment groove so that the first and second housing structures 510 and 520 may be in the unfolded state. At this time, at least partial surfaces of the second surfaces 582b and 592b of the first and second heat transfer members 582 and 592 may face each other.

In this state, the heat of the at least one first element 571a (e.g., the heat A1 in FIG. 5) transferred to the first heat transfer member 582 may be transferred to the second surface 592b of the second heat transfer member 592 by passing through (A2) the second surface 582b of the first heat transfer member 582, which face each other. As another example, the heat of the at least one second element 572a (e.g., the heat A1-1 in FIG. 5) transferred to the second heat transfer member 592 may be transferred to the second surface 582b of the first heat transfer member 582 by passing through (A2-1) the second surface 592b of the second heat transfer member 592, which face each other.

According to various embodiments, the first and second fastening portions 601 and 602 may be coupled to each other and, at the same time, enable the second surfaces 582b and 592b of the first and second heat transfer members 582 and 592 to come into strong contact. Accordingly, the first and second fastening portions 601 and 602 may further improve the close contact force of the second surfaces 582b and 592b of the first and second heat transfer members 582 and 592, and further improve the heat transfer function of the first and second heat transfer members 582 and 592, as well as lowering the contact heat resistance between the first and second heat transfer members 582 and 592.

According to various embodiments, as shown in FIGS. 10A and 10B described above, a first support member 601a for supporting the first fastening portion 601 may be formed between the first fastening portion 601 and the first hinge member 564a provided in the hinge structure 564, and a second support member 602a for supporting the second fastening portion 602 may be formed between the first fastening portion 601 and the second hinge member 564b provided in the hinge structure 564. Accordingly, the first and second support members 601a and 602a for supporting the first and second fastening portions 601 and 602 may be provided between the first and second fastening portions 601 and 602 and the first and second hinge members 564a and 564b so that the first and second support members 601a and 602a may support the first and second fastening portions 601 and 602 so as to facilitate coupling or separation thereof. In addition, the first and second support members 601a and 602a may support the second surfaces 582b and 592b of the first and second heat transfer members 582 and 592 such that they come into stronger contact when the first and second fastening portions 601 and 602 are coupled to each other.

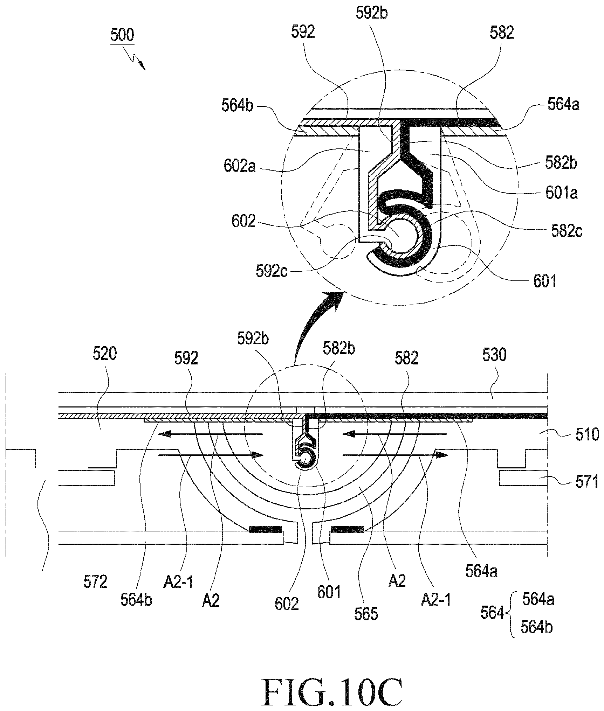

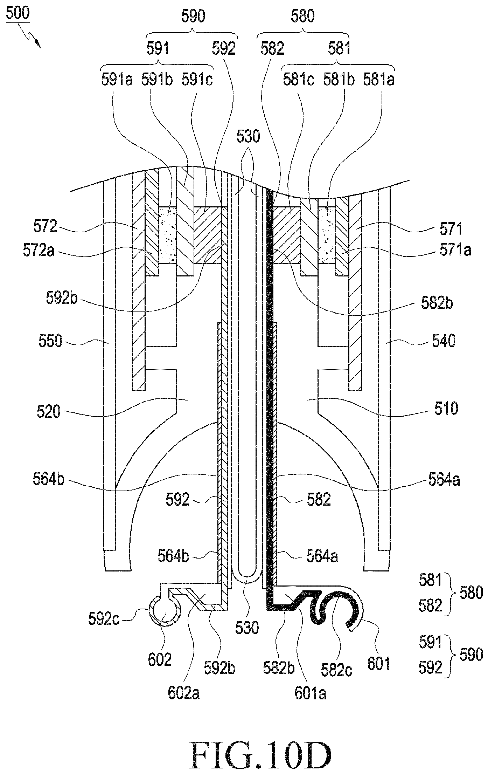

FIG. 10C is a side cross-sectional view illustrating another embodiment of first and second fastening members when an electronic device is in an unfolded state according to various embodiments of the disclosure, and FIG. 10D is a side cross-sectional view illustrating another embodiment of first and second fastening members when an electronic device is in a folded state according to various embodiments of the disclosure.

Referring to FIGS. 10C and 10D, the end of the second surface 582b of the first heat transfer member 582 may have a first contact portion 582c that extends from the second surface 582b and is formed on the inner surface of the first fastening portion 601, and the end of the second surface 592b of the second heat transfer member 592 may have a second contact portion 592c that extends from the second surface 592b and is formed on the outer circumferential surface of the second fastening portion 602. For example, the first contact portion 582c may be formed to surround the inner surface of the first fastening portion 601, and the second contact portion 592c may be formed to surround the outer circumferential surface of the second fastening portion 602. The first contact portion 582c may be formed to surround a first support structure 601a formed between the first fastening portion 601 and the first hinge structure 564a, and the second contact portion 592c may be formed to surround a second support structure 564b formed between the second fastening portion 602 and the second hinge structure 564b. In this state, when the first and second housing structures 510 and 520 are rotated and unfolded by the hinge structure 564, the second fastening portion 602 may be coupled to the first fastening portion 601 and, at the same time, the second contact portion 592c formed on the outer circumferential surface of the second fastening portion 602 may come into contact with the first contact portion 582c formed on the inner circumferential surface of the first fastening portion 601. For example, the heat of the at least one first element 571a (e.g., the heat A1 in FIG. 5) transferred to the first heat transfer member 582 may be transferred to the second surface 592b of the second heat transfer member 592 by passing through (A2) the second surface 582b of the first heat transfer member 582, which face each other. As another example, the heat of the at least one second element 572a (e.g., the heat A1-1 in FIG. 5B) transferred to the second heat transfer member 592 may be transferred to the second surface 582b of the first heat transfer member 582 by passing through (A2-1) the second surface 592b of the second heat transfer member 592, which face each other. At this time, the remaining heat that has not yet been transferred (e.g., the heat A1 and A1-1 in FIG. 5B) may be easily transferred from the first heat transfer member 582 to the second heat transfer member 592 or may be easily transferred from second heat transfer member 592 to the first heat transfer member 582 through the first and second contact portions 582c and 592c. Accordingly, the heat transfer efficiency of the first and second heat transfer members 582 and 592 may be further improved.

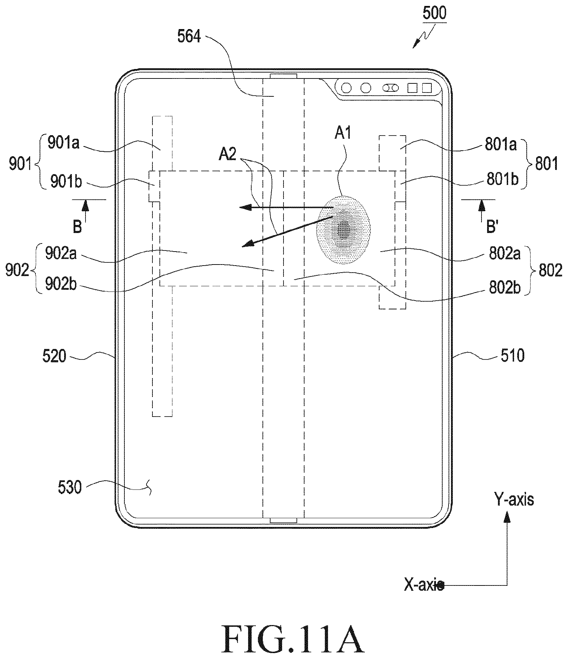

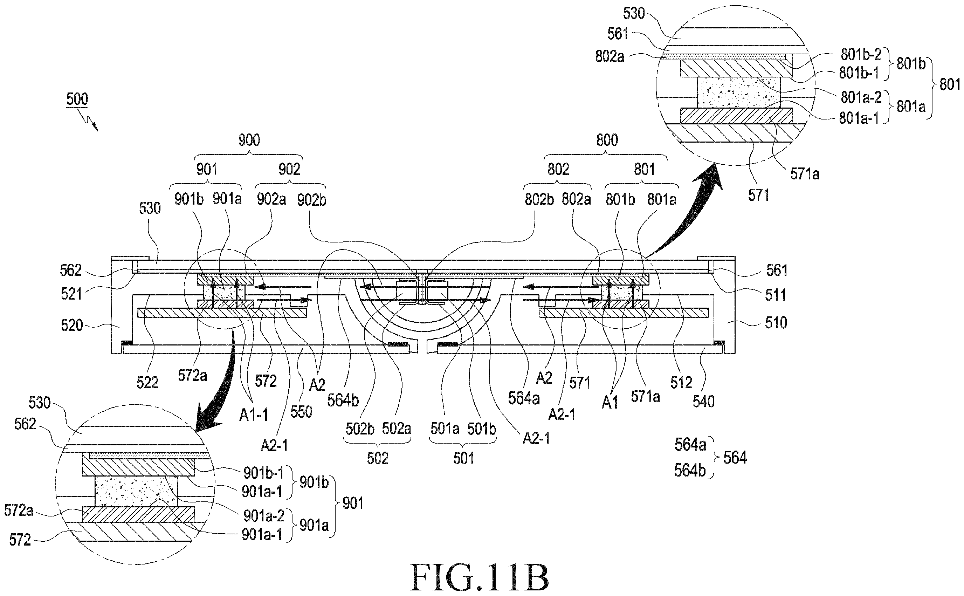

FIG. 11A is a diagram illustrating heat A1 distribution and heat transfer paths A2 of some elements included in a foldable electronic device 500 when the foldable electronic device 500 is in an unfolded status according to various other embodiments of the disclosure, which illustrates other configurations of a first heat transfer region (e.g., the first heat transfer region 800 in FIG. 10B) and a second heat transfer region (e.g., the second heat transfer region 900 in FIG. 10B) in a heat transfer structure, and FIG. 11B is a cross-sectional view taken along line B-B' in FIG. 11A, which is a side cross-sectional view illustrating the configuration of the first and second heat transfer regions 800 and 900.

Referring to FIGS. 11A and 11B, according to various embodiments, a heat transfer structure of the foldable electronic device 500 may include a hinge cover 565 for covering a hinge structure 564, first and second housing structures 510 and 520, first and second fastening members 501 and 502, first and second printed circuit boards 571 and 572, and first and second heat transfer structures 800 and 900. For example, the first and second housing structures 510 and 520 may be connected to the hinge structure 564 and rotate about the hinge structure 564 to be disposed in an unfolded state or folded state.

At least one of the elements of the foldable electronic device 500 including the heat transfer structures 800 and 900 may be the same as or similar to at least one of the elements of the foldable electronic device including the heat transfer structures 580 and 590 in FIG. 5A or 5B, so duplicate descriptions thereof will be omitted below.

The first and second fastening members 501 and 502 may be mounted on the hinge structure 564, and maintain the unfolded state or folded state of the first and second housing structures 510 and 520 according to attachment and detachment thereof. For example, the first fastening member 501 and the second fastening member 502 may include first and second seat portions 501a and 502a and first and second magnets 501b and 502b. The first seat portion 501a may be connected to a first hinge member 564a provided in the hinge structure 564, and the first magnet 501b may be seated on the first seat portion 501a. The second seat portion 502a may be connected to a second hinge member 564b provided in the hinge structure 564, and the second magnet 502b may be seated on the second seat portion 502a.

According to various embodiments, in the unfolded state of the first and second housing structures 510 and 520, the first and second fastening members 501 and 502 may be attached by the magnetic force of the first and second magnets 501b and 502b, and, at this time, the first and second housing structures 510 and 520 may be attached by the magnetic force of the first and second magnets 501b and 502b to maintain the unfolded state. In the folded state of the first and second housing structures 510 and 520, the first and second fastening members 501 and 502 may be separated from each other, and, at the same time, the first and second magnets 501b and 502b may also be separated. At this time, since the magnetic force does not affect the first and second housing structures 510 and 520 due to the separation of the first and second magnets 501b and 502b, the first and second housing structures 510 and 520 may be separated to maintain the folded state.

At least one of the elements of the first and second fastening members 501 and 502 may be the same as or similar to at least one of the elements of the first and second fastening members 501 and 502 in FIG. 6 or 7, so duplicate descriptions thereof will be omitted below.

At least one first element 571a may be mounted on one surface of the first printed circuit board 571, and at least one second element 572a may be mounted on at least a partial surface of the second printed circuit board 572. The first heat transfer structure 580 may be disposed in at least a portion of the first housing structure 510 and in at least a portion of the hinge structure 564, and the second heat transfer structure 590 may be disposed in at least a portion of the second housing structure 520 and in at least a portion of the hinge structure 564.

According to various embodiments, as shown in FIGS. 11A and 11B described above, the first heat transfer structure 800 may include a first heat transfer region 801 and a first heat transfer member 802. For example, the first heat transfer region 801 may include a first heat transfer portion 801a and a first cooling member 801b.

The first heat transfer portion 801a may form a first surface 801a-1 and a second surface 801a-2, the first surface 801a-1 of the first heat transfer portion 801a may face at least a partial surface of the at least one first element 571a, and the second surface 801a-2 opposite the first surface 801a-1 of the first heat transfer portion 801a may face a first surface 801b-1 of the first cooling member 801b, which will be described later.

The first cooling member 801b may form a first surface 801b-1 and a second surface 801b-1, the first surface 801b-1 of the first cooling member 801b may face the second surface of the first heat transfer portion 801a, and the second surface 801b-2 opposite the first surface 801b-1 of the first cooling member 801b may face at least a partial surface of one end 802a of the first heat transfer member 802, which will be described later. At least a partial surface of the opposite end 802b of the first heat transfer member 802 may face the opposite end 902b of the second heat transfer member, which will be described later.

According to various embodiments, the second surface 801b-2 of the first cooling member 801b may be disposed to face at least a partial surface of the first surface 511 of the first housing structure 510. For example, the second surface 801b-2 of the first cooling member 801b may face at least a partial surface of one end 802a of the first heat transfer member 802 while facing at least a partial surface of the first surface 511 of the first housing structure 510.

The second heat transfer structure 900 may include a second heat transfer region 901 and a second heat transfer member 902. For example, the second heat transfer region 901 may include a second heat transfer portion 901a and a second cooling member 901b.

The second heat transfer portion 901a may form a first surface 901a-1 and a second surface 901a-1, the first surface 901a-1 of the second heat transfer portion 901a may face at least a partial surface of the at least one second element 571b, and the second surface 901a-2 opposite the first surface 901a-1 of the second heat transfer portion 901a may face a first surface 901b-1 of the second cooling member 901b, which will be described later.

The second cooling member 901b may form a first surface 901b-1 and a second surface 901b-2, the first surface 901b-1 of the second cooling member 901b may face the second surface 901a-2 of the second heat transfer portion 901a, and the second surface 901b-2 opposite the first surface 901b-1 of the second cooling member 901b may face at least a partial surface of one end 902a of the second heat transfer member 902. At least a partial surface of the opposite end 902b of the second heat transfer member 902 may face the opposite end 802b of the first heat transfer member 802.

According to various embodiments, the second surface 901b-2 of the second cooling member 901b may be disposed to face at least a partial surface of the first surface 521 of the second housing structure 520. For example, the second surface 901b-2 of the second cooling member 901b may face at least a partial surface of one end 902a of the second heat transfer member 902 while facing at least a partial surface of the first surface 521 of the second housing structure 520.

In this state, when the first and second housing structures 510 and 520 are rotated and unfolded by the hinge structure 564, the first magnet 501b of the first fastening member 501 and the second magnet 502b of the second fastening member 502 may be attached to each other by magnetic force, and, at the same time, the first and second housing structures 510 and 520 may be in the unfolded state. At this time, at least partial surfaces of the opposite ends of the first and second heat transfer members 802 and 902 disposed on at least partial surfaces of the first and second fastening members 501 and 502 may face each other.

In this state, as shown FIGS. 11A and 11B described above, the at least one first element 571a may generate heat A1 during the signal processing operation, and the generated heat A1 may be transferred to the first heat transfer portion 801a of the first heat transfer region 801, and the heat A1 transferred to the first heat transfer portion 801a may be transferred to the first cooling member 801b. The first cooling member 801b may primarily cool the transferred heat A1. At this time, the heat A1 that has not yet been cooled by the first cooling member 801b may be transferred to the first heat transfer member 802, and the heat A1 transferred to the first heat transfer member 802 may be transferred to the second heat transfer member 902. For example, since the first and second heat transfer members 802 and 902 face each other by the first and second fastening members 501 and 502, the heat A1 transferred to the first heat transfer member 802 may flow (A2) to the second heat transfer member 902. Accordingly, the heat A1 may be transferred from the first housing structure 510 in a high-temperature region to the second housing structure 520 in a low-temperature region through the first and second heat transfer members 802 and 902 to be diffused or dispersed.

As described above, the high-temperature heat A1 generated in the at least one first element 571a may be transferred to the second heat transfer member 902 disposed in the second housing structure 520 by passing through (A2) the first heat transfer member 802 disposed in the first housing structure 510 so that the high-temperature heat A1 generated in the first element 571a may be rapidly diffused or dispersed from the first housing structure 510 in a high-temperature state to the second housing structure 520 in a low-temperature state, thereby preventing the high-temperature heat A1 from being concentrated only in the first housing structure 510 and rapidly cooling the high-temperature heat A1.

Accordingly, heat A1 generated from the first and second elements 571a and 571b may be efficiently transferred to a lower-temperature portion through the first and second heat transfer members 802 and 902. Therefore, it is possible to make a stable operating environment for the at least one first or second element 571a or 571b.

As another example, as shown in FIG. 11B mentioned above, the second heat transfer member 902 may transfer the high-temperature heat A1-1 of the at least one second element 571b transferred to the second heat transfer region 901 to the second heat transfer portion 901a and the second cooling member 901b, and transfer the heat A1-1 transferred to the second cooling member 901b to the first heat transfer member 802. Likewise, the high-temperature heat A1-1 may be transferred to the first heat transfer member 802 by passing through (A2-1) the second heat transfer member 902. Accordingly, the high-temperature heat A1-1 may be rapidly transferred from the second housing structure 520 to the first housing structure 510 in a low-temperature state. Therefore, it is possible to prevent the high-temperature heat A1-1 from being concentrated only in the second housing structure 520.

As described above, the first and second heat transfer regions 801 and 901 may constitute one heat transfer portion 801a or 901a without requiring an additional heat transfer portion, thereby reducing the number of components of the product to reduce the manufacturing cost and enabling a simplified assembly process. In addition, the heat A1 and A1-1 generated from the at least one first or second element 571a or 571b may be rapidly transferred to the first heat transfer member 802 or the second heat transfer member 902, thereby further preventing concentration in either the first housing structure 510 or the second housing structure 520. As described above, the first and second heat transfer regions 801 and 901 may more effectively cool the heat A1 or A1-1 transferred to the first housing structure 510 or the second housing structure 520, and reduce the temperature of the at least one first or second element 571a or 571b or the temperature of the space in which the at least one first or second element 571a or 571b is disposed in the foldable electronic device 500.

According to various embodiments, the first and second cooling members 801b and 901b may include at least one of a heat pipe and a heat chamber. The first and second cooling members 801b and 901b may be configured as at least one of a heat pipe or a heat chamber, thereby further improving the cooling function of the first and second cooling members 801b and 901b. In the embodiment, although the first and second cooling members 801b and 901b are described as examples of a heat pipe or a heat chamber, they are not limited thereto. For example, any configuration capable of transferring, to the first and second heat transfer members 802 and 902, the heat transferred from the first and second heat transfer portions 801a and 901a (e.g., the heat A1 and A1-1 in FIG. 11B) may be variously applied to the first and second cooling members 801b and 901b.

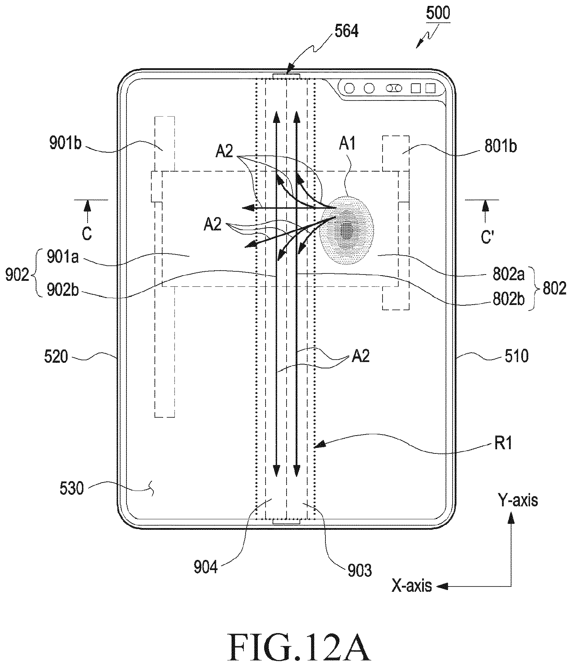

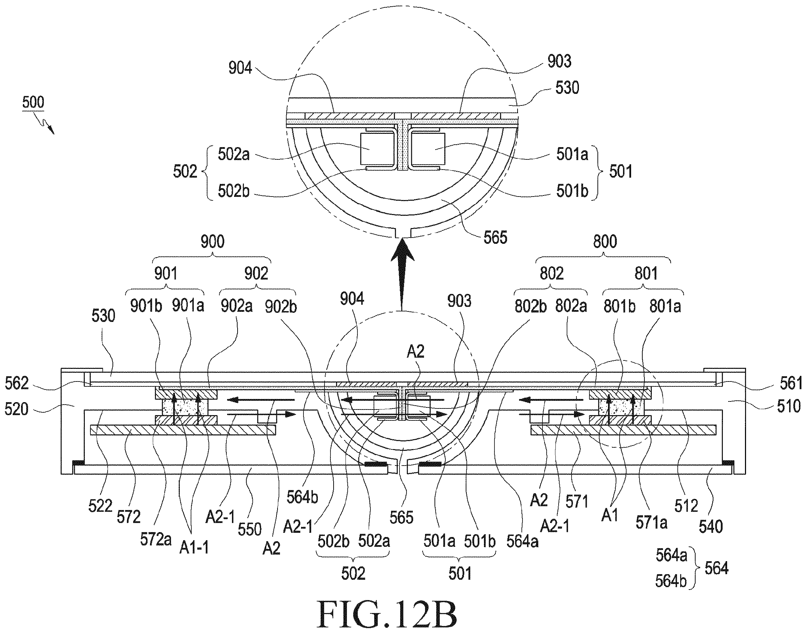

FIG. 12A is a diagram illustrating heat A1 distribution and heat transfer paths A2 of some elements included in a foldable electronic device 500 when the foldable electronic device is in an unfolded state according to various other embodiments of the disclosure, which illustrates other configurations of the heat transfer regions 801 and 901 in the heat transfer structures 800 and 900, and FIG. 12B is a cross-sectional view taken along line C-C' in FIG. 12A, which is a side cross-sectional view illustrating third and fourth cooling members 903 and 904 included in the heat transfer regions 801 and 901.

Referring to FIGS. 12A and 12B, according to various embodiments, the heat transfer structure of the foldable electronic device 500 may include a hinge cover 565 that covers a hinge structure 564, first and second housing structures 510 and 520, first and second fastening members 501 and 502, first and second printed circuit boards 571 and 572, and first and second heat transfer structures 800 and 900. For example, the first and second housing structures 510 and 520 may be connected to the hinge structure 564 and rotate about the hinge structure 564 to be disposed in an unfolded state or a folded state.

At least one of the elements of the foldable electronic device 500 including the heat transfer structures 800 and 900 may be the same as or similar to at least one of the elements of the foldable electronic device including the heat transfer structures in FIG. 11A or 11B, so duplicate descriptions thereof will be omitted below.

As shown in FIGS. 12A and 12B described above, a third cooling member 903 and a fourth cooling member 904 may be included in the hinge structure 564. The third cooling member 903 may be disposed to face at least a partial surface of the first heat transfer member 802 included in the first heat transfer structure 800. The fourth cooling member 904 may be disposed to face at least a partial surface of the second heat transfer member 902 included in the second heat transfer structure 900.

In this state, for example, the heat A1 generated in the first element 571a mounted on the first printed circuit board 571 and transferred to the first heat transfer member 802 may be transferred both to the hinge structure 564 and to the third cooling member 903, and the transferred heat A1 may be primarily cooled by the third cooling member 903. At this time, the remaining heat A1 that has not yet been cooled by the third cooling member 903 may also be transferred to the fourth cooling member 904. At this time, the transferred heat A1 may be secondarily cooled by the fourth cooling member 904. For example, the heat A1 may flow (A2) from the third cooling member 903 to the fourth cooling member 904 through the first and second heat transfer members 802 and 902 to be cooled. In addition, the heat A1 may flow (A2) from the first housing structure 510 to the second housing structure 920 through the first and second heat transfer members 802 and 902.

As another example, the heat A1-1 generated in the second element 572a mounted on the second printed circuit board 572 and transferred to the second heat transfer member 902 may be transferred to the fourth cooling member 904 inside the hinge structure 564. The transferred heat A1-1 may be primarily cooled by the fourth cooling member 904. At this time, the remaining heat A1-1 that has not yet been cooled by the fourth cooling member 904 may be transferred to the third cooling member 903. At this time, the transferred heat A1-1 may be secondarily cooled by the third cooling member 903. For example, the heat A1-1 may flow (A2-1) from the fourth cooling member 904 to the third cooling member 903 through the first and second heat transfer members 802 and 902 to be cooled, and the heat A1-1 may flow (A2-1) from the second housing structure 520 to the first housing structure 910 through the first and second heat transfer members 802 and 902.

According to various embodiments, the third and fourth cooling members 903 and 904 may be configured as at least one of a heat pipe or a heat chamber, thereby further improving the cooling function of the third and fourth cooling members 903 and 904.

As shown FIGS. 12A and 12B described above, the third and fourth cooling members 903 and 904 may cool the heat (e.g., A1 and A1-1) transferred to the space formed in the Y-axis direction of the hinge structure 564 so that the heat A1 and A1-1 transferred from the first heat transfer member 802 or the second heat transfer member 902 may be primarily cooled by the third and fourth cooling structures 903 and 904 of the hinge structure 564. Accordingly, the third and fourth cooling structures 903 and 904 may more effectively cool the heat A1 and A1-1 transferred to the hinge structure 564.

As another example, as shown in FIG. 12A mentioned above, the heat A1 transferred by flowing (A2) to the third and fourth cooling structures 903 and 904 may be transferred to the space formed in the Y-axis direction of the hinge structure 564, and the transferred heat A1 may be applied to a folding portion R1 formed in the flexible display 530 included in the first and second housing structures 510 and 520. For example, since the transferred heat A1 is applied to the folding portion R1 of the flexible display 530, the applied heat A1 may prevent the folding portion R1 from being deformed. In addition, the folding portion R1 of the flexible display 530 may prevent the formation of fold marks produced by repeated folding or unfolding of the flexible display using the applied heat A1 (e.g., the effect like an iron), and the folding portion R1 may prevent cracks and damage caused by an external environment (e.g., cold weather).

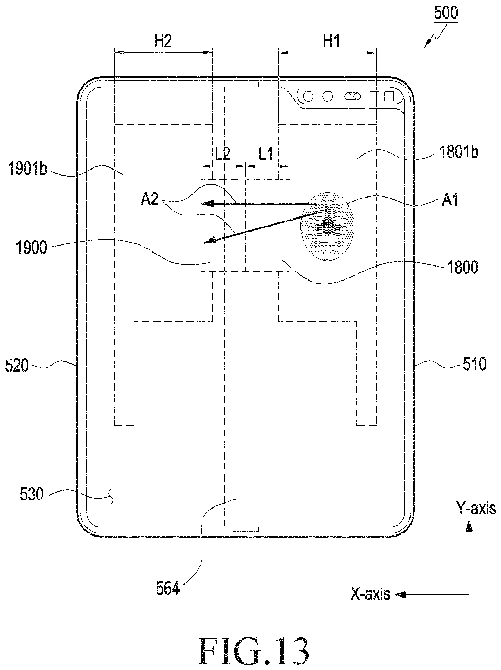

FIG. 13 is a diagram illustrating another configuration of a heat transfer structure (e.g., the heat transfer structures 800 and 900 in FIG. 11B) when a foldable electronic device 500 is in an unfolded state according to various embodiments of the disclosure, which illustrates heat A1 distribution and heat transfer paths A2 of some elements included in the foldable electronic device, and illustrates side surface widths L1 and L2 of the first and second heat transfer members 1800 and 1900 and side surface widths H1 and H2 of the first and second cooling members 1801b and 1901b.

Example: At least one of the elements of the foldable electronic device 500 including the heat transfer structures may be the same as or similar to at least one of the elements of the foldable electronic device 500 including the heat transfer structures 800 and 900 in FIG. 11A or 11B, so duplicate descriptions thereof will be omitted below.

Referring to FIG. 13, the heat transfer structures (e.g., the heat transfer structures 800 and 900 in FIG. 11B) may include first and second heat transfer regions (e.g., the first and second heat transfer regions 801 and 901 in FIG. 11B), first and second cooling members 1801b and 1901b, and first and second heat transfer members 1800 and 1900. For example, when the first and second housing structures 510 and 520 are viewed from above in the unfolded state, the first cooling member 1801b may be included in the first housing structure 510, and the second cooling member 1901b may be included in the second housing structure 520.

At least one surface of the first cooling member 1801b may face at least one surface of the first heat transfer member 1800, and at least one surface of the second cooling member 1901b may face at least one surface of the second heat transfer member 1900.

When the first and second housing structures 510 and 520 are viewed from above in the unfolded state, the side surface widths L1 and L2 of the first and second heat transfer members 1800 and 1900 may be formed to be smaller than the side surface widths H1 and H2 of the first and second cooling members 1801b and 1901b, so that the heat A1 transferred to the first heat transfer region (e.g., the first heat transfer region 801 in FIG. 11B) may be rapidly transferred from the first cooling member 1801b to the second cooling member 1901b, and thus the heat A1 may be diffused or dispersed through the second cooling member 1901b. For example, the heat A1 may flow from the first cooling member 1801b to the second cooling member 1901b through the first and second heat transfer members 1800 and 1900, and the heat A1 may also flow (A2) from the first housing structure 510 to the second housing structure 520 through the first and second heat transfer members 1800 and 1900.

As another example, the heat (e.g., the heat A1-1 in FIG. 11B) transferred to the second heat transfer region (e.g., the second heat transfer region 801 in FIG. 11B) may be rapidly transferred from the second cooling member 1901b to the first cooling member 1801b, and thus the heat (e.g., heat A1-1 in FIG. 11B) may be diffused or dispersed through the first cooling member 1901b. For example, the heat (e.g., the heat A1-1 in FIG. 11B) may be transferred from the second cooling member 1901b to the first cooling member 1801b through the first and second heat transfer members 1800 and 1900, and the heat (e.g., the heat A1-1 in FIG. 11B) may also flow (e.g., flow A2-1 in FIG. 11B) from the second housing structure 520 to the first housing structure 510 through the first and second heat transfer members 1800 and 1900.

Accordingly, the first and second cooling members 1801b and 1901b may primarily cool the heat A1 or A1-1 transferred to the first heat transfer region 800 or the second heat transfer region 900, and, at the same time, the remaining heat A1 or A1-1 that has not yet been cooled may be rapidly transferred to the first heat transfer member 1800 or the second heat transfer member 1900.

As described above, since the overall sizes of the first and second cooling members 1801b and 1901b may be formed to be larger than the overall sizes of the first and second heat transfer members 1800 and 1900, the first and second cooling members 1801b and 1901b may rapidly cool or transfer the high-temperature heat A1 or A1-1 of the first heat transfer member 1800 or the second heat transfer member 1900. Accordingly, the first and second cooling members 1801b and 1901b may efficiently cool or transfer the high-temperature heat A1 of the first housing structure 510 to the second housing structure 520 in a lower-temperature state, and, as another example, the first and second cooling members 1801b and 1901b may efficiently cool or transfer the high-temperature heat A1-1 of the second housing structure 520 to the first housing structure 510 in a lower-temperature state.

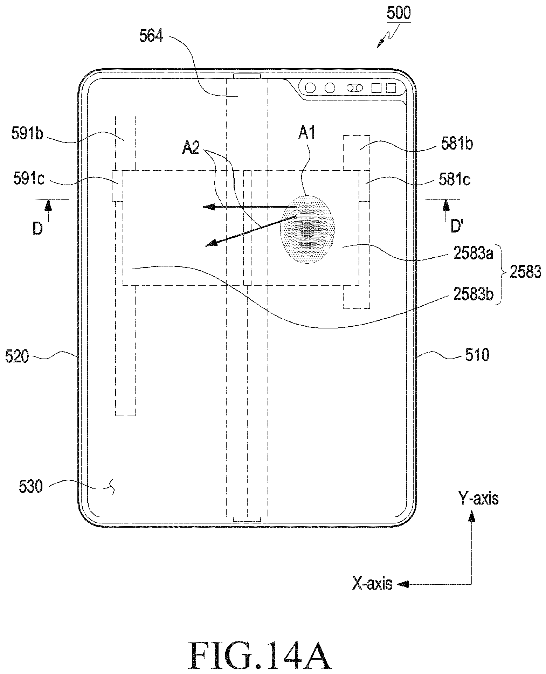

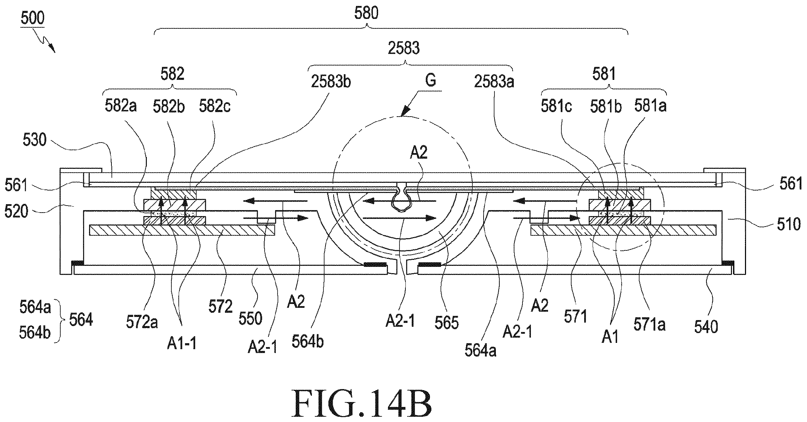

FIG. 14A is a diagram illustrating heat A1 distribution and heat transfer paths A2 of some elements included in a foldable electronic device 500 when the foldable electronic device 500 is in an unfolded state according to various other embodiments of the disclosure, which illustrates another configuration of the heat transfer member 583 in configuration of the heat transfer structure 580, and FIG. 14B is a cross-sectional view taken along line D-D' in FIG. 14A, which illustrates the configuration of the heat transfer structure 580 when the foldable electronic device 500 is in an unfolded state according to various other embodiments of the disclosure.

Referring to FIGS. 14A and 14B, according to various embodiments, the heat transfer structure of the foldable electronic device 500 may include first and second housing structures 510 and 520, a hinge structure 564, a hinge cover 565 that covers the hinge structure 564, first and second printed circuit boards 571 and 572, and a heat transfer structure 580. For example, the first and second housing structures 510 and 520 may be connected to the hinge structure 564 and rotate about the hinge structure 564 to be disposed in an unfolded state or folded state. The hinge structure 564 may include first and second hinge members 564a and 564b supporting the hinge structure 564.

At least one first element 571a may be mounted on one surface of the first printed circuit board 571, and at least one second element 572a may be mounted on at least a portion of the second printed circuit board 572. The heat transfer structure 580 may be disposed in at least a portion of the first housing structure 510 and in at least a portion of the hinge structure 564, and the heat transfer structure 580 may be disposed in at least a portion of the second housing structure 520 and in at least a portion of the hinge structure 564.

According to various embodiments, the heat transfer structure 580 may include first and second heat transfer regions 581 and 582 and a heat transfer member 2583. For example, the first heat transfer region 581 may include a first heat transfer portion 581a, a first cooling member 581b, and a second heat transfer portion 581c, the first heat transfer portion 581a may be disposed to face at least a partial surface of the at least one first element 571a, the first cooling member 581b may be disposed to face at least a partial surface of the first heat transfer portion 581a, the second heat transfer portion 581c may be disposed to face at least a partial surface of the first cooling member 581b, at least a partial surface of the second heat transfer portion 581c may face at least a partial surface of the first cooling member 581b, and at least another partial surface opposite at least a partial surface of the second heat transfer portion 581c may face at least a partial surface of one end 2583a of the heat transfer member 2583.

The second heat transfer region 582 may include a third heat transfer portion 582a, a second cooling member 582b, and a fourth heat transfer portion 582c, the third heat transfer portion 582a may be disposed to face at least a partial surface of the at least one second element 572a, the second cooling member 582b may be disposed to face at least a partial surface of the third heat transfer portion 582a, the fourth heat transfer portion 582c may be disposed to face at least a partial surface of the second cooling member 582b, at least a partial surface of the fourth heat transfer portion 582c may face at least a partial surface of the second cooling member 582b, and at least another partial surface opposite at least a partial surface of the fourth heat transfer portion 582c may face at least a partial surface of the opposite end 2583b of the heat transfer member 2583.

At least one of the elements of the foldable electronic device 500 including the heat transfer structure 580 may be the same as or similar to at least one of the elements of the foldable electronic device including the heat transfer structure 580 in FIG. 5A or 5B, so duplicate descriptions thereof will be omitted below.

According to various embodiments, the heat transfer member 2583 may be disposed between the first and second heat transfer regions 581 and 582. For example, one end 2583a of the heat transfer member 2583 may face at least a partial surface of the second heat transfer portion 581c of the first heat transfer region 581, and the opposite end 2583b of the heat transfer member 2583 may face at least a partial surface of the fourth heat transfer portion 582c of the second heat transfer region 582.

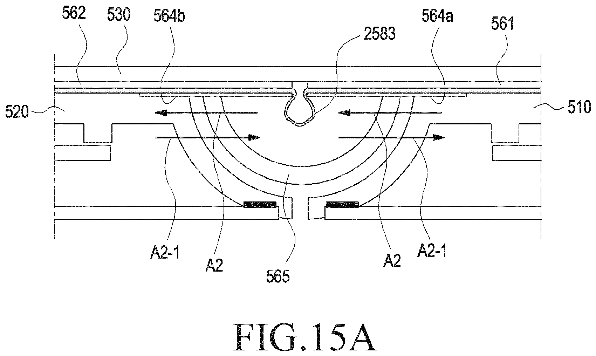

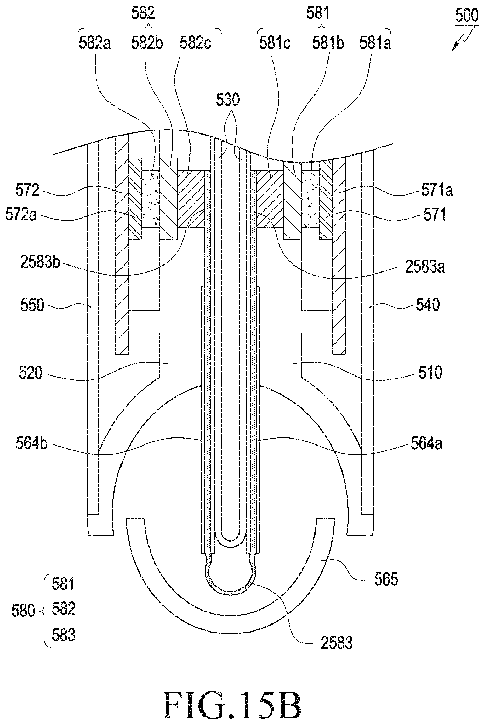

FIG. 15A is an enlarged cross-sectional view of the portion G in FIG. 14B, which illustrates the configurations of a heat transfer structure 580 when a foldable electronic device 500 is in an unfolded state according to various embodiments of the disclosure, and FIG. 15B is an enlarged cross-sectional view of FIG. 14B, which illustrates the configuration of a heat transfer structure 580 when a foldable electronic device 500 is in an unfolded state according to various embodiments of the disclosure.

As shown in FIG. 15A, in the unfolded state of the first and second housing structures 510 and 520, the heat transfer member 2583 may transfer the heat of the at least one first element 571a (e.g., the heat A1 in FIG. 14B) transferred to the first heat transfer region 581 to the second heat transfer region 582. Accordingly, the heat of the at least one first element 571a (e.g., the heat A1 in FIG. 14A) may flow (A2) from the first housing structure 510 to the second housing structure 520.

As another example, the heat transfer member 2583 may transfer the heat A1-1 of the at least one second element 572a, which is transferred to the second heat transfer region 582, to the first heat transfer region 581. Accordingly, the heat A1-1 of the at least one second element 572a may flow (A2-1) from the second housing structure 520 to the first housing structure 510.

As shown in FIG. 15B, even in the folded state of the first and second housing structures 510 and 520, the heat transfer member 2583 may connect the first heat transfer region 581 and the second heat transfer region 582. Thus, in the folded state, the heat transfer member 2583 may transfer the heat of the at least one first element 571a (e.g., heat A1 in FIG. 14A) transferred to the first heat transfer region 581 to the second heat transfer region 582. For example, the heat of the at least one first element 571a (e.g., the heat A1 in FIG. 14A) may be transferred from the first heat transfer region 581 to the second heat transfer region 582 through the heat transfer member 2583. Accordingly, the heat of the at least one first element 571a (e.g., the heat A1 in FIG. 14A) may flow (e.g., flow A2 in FIG. 14B) from the first housing structure 510 to the second housing structure 520. As another example, when the first and second housing structures 510, 520 are in the folded state, the heat transfer member 2583 may transfer the heat of the at least one second element 572a (e.g., the heat A1-1 in FIG. 14B), which is transferred to the second heat transfer region 582, from the first heat transfer region 581 to the second heat transfer region 582. For example, the heat of the at least one second element 572a (e.g., the heat A1-1 in FIG. 14B) may be transferred from the second heat transfer region 582 to the first heat transfer region 581 through the heat transfer member 2583. Accordingly, the heat of the at least one second element 572a (e.g., the heat A1-1 in FIG. 14B) may flow (e.g., flow A2-1 in FIG. 14B) from the second housing structure 520 to the first housing structure 510.

For example, as shown in FIGS. 14A and B and 15A and B described above, the heat transfer member 2583 may be disposed between the first and second heat transfer regions 581 and 582, and may transfer the high-temperature heat A1 generated in the first element 571a from the first heat transfer region 581 to the second heat transfer region 582 in the unfolded state or folded state. As another example, the heat transfer member 2583 may transfer the high-temperature heat A1-1 generated in the second element 572a from the second heat transfer region 582 to the first heat transfer region 581 in the unfolded state or the folded state.

As described above, the heat transfer member 2583 may be disposed between the first and second heat transfer regions 581 and 582, and, in the unfolded state or the folded state, connect the first and second heat transfer regions 581 and 582 to each other, thereby transferring the high-temperature heat A1 or A1-1 generated in the first element 571a or the second element 571a, 572a to the first heat transfer region 581 or the second heat transfer region 582, regardless of the unfolded state or folded state of the first and second housing structures 510 and 520. Accordingly, the heat transfer member 2583 may improve the transfer of the high-temperature heat A1 or A1-1 generated in the first element 571a or the second element 571a, 572a. Therefore, the high-temperature heat A1 generated in the first element 571a may be more efficiently transferred, dispersed, and cooled from the first housing structure 510 having a high temperature to the second housing structure 520 having a lower temperature, or the high-temperature heat A1-1 generated in the second element 572a may be more efficiently transferred, dispersed, and cooled from the second housing structure 520 having a high temperature to the first housing structure 510 having a lower temperature. The dispersed and cooled heat may further reduce the temperatures of the first and second elements 571a and 572a or the temperature of the space in which the first and second elements 571a and 572a are disposed in the foldable electronic device 500.

According to various embodiments, the heat transfer member 2583 may be formed of a flexible sheet member such that the flexible sheet member may connect the first and second heat transfer regions 581 and 582 when the first and second housing structures 510 and 520 are operated in the unfolded state or folded state. For example, the heat transfer member 2583 made of the flexible sheet member may not be damaged due to ductility when the first and second housing structures 510 and 520 are operated in the unfolded state or folded state. Accordingly, the heat transfer member 2583 may connect the first and second heat transfer regions 581 and 582 to each other even during the operation in the unfolded state and folded state.

According to various embodiments, the heat transfer member 2583 may include at least one of a heat pipe, a heat chamber, and a graphite or copper sheet. In this embodiment, although the heat transfer member 2583 is described as an example of a heat pipe, a heat chamber, or a graphite or copper sheet, it is not limited thereto. For example, any configuration capable of transferring the heat A1, which is transferred to the first heat transfer region 581 due to the first element 571a, from the first heat transfer region 581 to the second heat transfer region 582 or capable of transferring the heat A1-1, which is transferred to the second heat transfer region 582 due to the second element 572a, from the second heat transfer region 582 to the first heat transfer region 581 may be variously applied to the heat transfer member 2583.

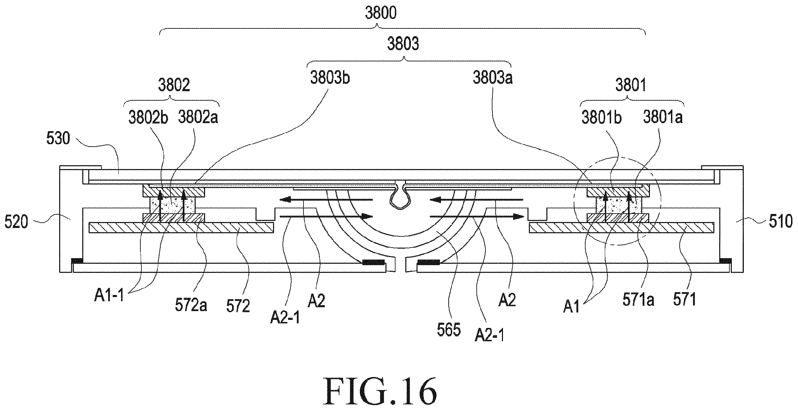

FIG. 16 is an enlarged cross-sectional view of D-D' in FIG. 14A, which is a side cross-sectional view illustrating other configurations of heat transfer regions 3801 and 3802 in a heat transfer structure 3800 when an electronic device is in an unfolded state according to various embodiments of the disclosure.

Referring to FIG. 16, according to various embodiments, a heat transfer structure 3800 of the foldable electronic device 500 may include a hinge cover 565 that covers a hinge structure (e.g., the hinge structure 564 in FIG. 14B), first and second housing structures 510 and 520, first and second printed circuit boards 571 and 572, and a heat transfer structure 3800. For example, the first and second housing structures 510 and 520 may be connected to the hinge structure 564 and rotate about the hinge structure 564 to be disposed in an unfolded state or folded state.

At least one of the elements of the foldable electronic device 500 including the heat transfer structure 3800 may be the same as or similar to at least one of the elements of the foldable electronic device including the heat transfer structure in FIG. 14A or 14B, so duplicate descriptions thereof will be omitted below.

At least one first element 571a may be mounted on one surface of the first printed circuit board 571, and at least one second element 572a may be mounted on at least a partial surface of the second printed circuit board 572. The heat transfer structure 3800 may be disposed in at least a portion of the first housing structure 510 and in at least a portion of the hinge structure 564, and the heat transfer structure 3800 may be disposed in at least a portion of the second housing structure 520 and in at least a portion of the hinge structure (e.g., the hinge structure 564 in FIG. 14B).

According to various embodiments, as shown in FIG. 16 described above, the heat transfer structure 3800 may include first and second heat transfer regions 3801 and 3802 and a heat transfer member 3803. For example, the first heat transfer region 3801 may include a first heat transfer portion 3801a and a first cooling member 3801b, at least a partial surface of the first heat transfer portion 3801a may face at least a partial surface of the at least one first element 571a, and at least another partial surface opposite at least the partial surface of the first heat transfer portion 3801a may face at least a partial surface of the first cooling member 3801b, which will be described later. At least a partial surface of the first cooling member 3801b may face at least the partial surface of the first heat transfer portion 3801a, and at least another partial surface opposite at least the partial surface of the first cooling member 3801b may face at least a partial surface of one end 3803a of the heat transfer member 3803, which will be described later.

The second heat transfer region 3802 may include a second heat transfer portion 3802a and a second cooling member 3802b. For example, at least a partial surface of the second heat transfer portion 3802a may face at least a partial surface of the at least one second element 572a, and at least another partial surface opposite at least the partial surface of the second heat transfer portion 3802a may face at least a partial surface of the second cooling member 3802b, which will be described later. At least a partial surface of the second cooling member 3802b may face at least the partial surface of the second heat transfer portion 3802a, and at least another partial surface opposite at least the partial surface of the second cooling member 3802b may face at least a partial surface of the opposite end 3803b of the heat transfer member 3803, which will be described later.

As shown in FIG. 16 described above, in the unfolded state of the first and second housing structures 510 and 520, the heat transfer member 3803 may transfer the heat A1 of the at least one element 571a, which is transferred to the first heat transfer region 3801, to the second heat transfer region 3802. For example, the transferred heat A1 of the at least one first element 571a may flow (A2) through the heat transfer member 3803 to be transferred from the first heat transfer region 3801 to the second heat transfer region 3802. Accordingly, the heat A1 of the at least one first element 571a may flow (A2) to be transferred from the first housing structure 510 to the second housing structure 520 through the heat transfer member 3803.

As another example, the heat transfer member 3803 may transfer, to the first heat transfer region 3801, the heat A1-1 of the at least one second element 572a transferred to the second heat transfer region 3802. At this time, the transferred heat A1-1 of the at least one second element 572a may flow (A2-1) to be transferred from the second heat transfer region 3802 to the first heat transfer region 3801 through the heat transfer member 3803. Accordingly, the heat A1-1 of the at least one second element 572a may flow (A2-1) to be transferred from the second housing structure 520 to the first housing structure 510 through the heat transfer member 3803.

According to various embodiments, even when the first and second housing structures 510 and 520 are in the folded status, the heat transfer member 3803 may connect the first heat transfer region 3801 and the second heat transfer region 3802. Thus, in the folded status, the heat transfer member 3803 may transfer, to the second heat transfer region 3802, the heat A1 of the at least one first element 571a transferred to the first heat transfer region 3801. As another example, even in the folded status of the first and second housing structures 510 and 520, the heat transfer member 3803 may connect the first heat transfer region 3801 and the second heat transfer region 3802, and in this state, the heat transfer member 3803 may transfer, to the first heat transfer region 3801, the heat A1-1 of the at least one second element 572a transferred to the second heat transfer region 3802.

According to various embodiments, the heat transfer member 3803 may be formed of a flexible sheet member.

As described above, the heat transfer member 3803 made of the flexible sheet member may be disposed between the first and second heat transfer regions 3801 and 3802, and, in the unfolded state or the folded state, connect the first and second heat transfer regions 3801 and 3802 to each other, thereby transferring the heat A1 and A1-1 generated in the first and second elements 571a and 572a to the first heat transfer region 3801 or the second heat transfer region 3802, regardless of the unfolded state or folded state of the first and second housing structures 510 and 520. Accordingly, the heat transfer member 3803 may improve the transfer of the heat A1 or A1-1 generated in the first element 571a or the second element 572a. Therefore, the heat A1 generated in the first element 571a may be more efficiently transferred, dispersed, and cooled from the first housing structure 510 having a high temperature to the second housing structure 520 having a lower temperature. Alternatively, the heat A1-1 generated in the second element 572a may be more efficiently transferred, dispersed, and cooled from the second housing structure 520 having a high temperature to the first housing structure 510 having a lower temperature.

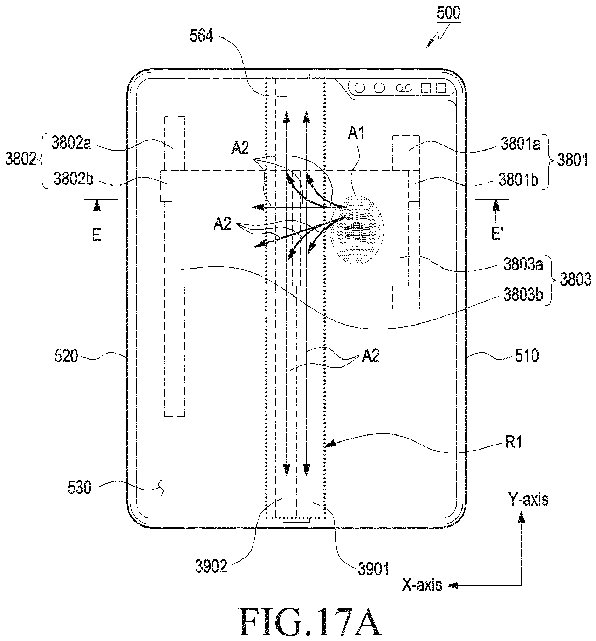

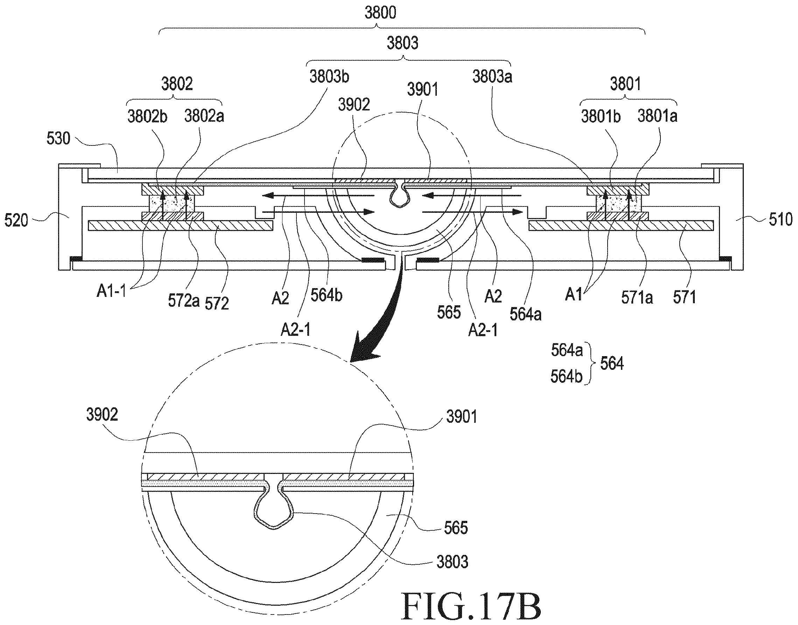

FIG. 17A is a diagram illustrating heat A1 distribution and heat transfer paths A2 of some elements included in a foldable electronic device 500 when the foldable electronic device 500 is in an unfolded state according to various other embodiments of the disclosure, which illustrates another configuration of a heat transfer region in a heat transfer structure, and FIG. 17B is an enlarged cross-sectional view taken along line E-E' in FIG. 17A, which is a side cross-sectional view illustrating another configuration of heat transfer region 3801 or 3802 in a heat transfer structure 3800 when a foldable electronic device (e.g., the foldable electronic device 500 in FIG. 14B) is in an unfolded state according to various embodiments of the disclosure

Referring to FIGS. 17A and 17B, according to various embodiments, the foldable electronic device 500 may include first and second housing structures 510 and 520, a hinge structure (e.g., the hinge structure 564 in FIG. 14B), a hinge cover 565 that covers the hinge structure 564, first and second printed circuit boards 571 and 572, a heat transfer structure 3800, and third and fourth cooling members 3901 and 3902. For example, the first and second housing structures 510 and 520 may be connected to the hinge structure 564 and rotate about the hinge structure 564 to be disposed in an unfolded state or folded state.

At least one of the elements of the foldable electronic device 500 including the heat transfer structure 3800 may be the same as or similar to at least one of the elements of the foldable electronic device 500 including the heat transfer structure 580 in FIG. 14A or 14B, so duplicate descriptions thereof will be omitted below.

According to various embodiments, the heat transfer structure 3800 may include first and second heat transfer regions 3801 and 3802, and a heat transfer member 3803. For example, the first heat transfer region 3801 may include a first heat transfer portion 3801a and a first cooling member 3801b, the first heat transfer portion 3801a may be disposed to face at least a partial surface of the at least one first element 571a, and the first cooling member 3801b may be disposed to face at least one surface of the first heat transfer portion 3801a. At least a partial surface of the first cooling member 3801b may face at least one surface of the first heat transfer portion 3801a, and at least another partial surface opposite at least the partial surface of the first cooling member 3801b may face at least a partial surface of one end 3803a of the heat transfer member 3803.

The second heat transfer region 3802 may include a second heat transfer portion 3802a and a second cooling member 3802b. The second heat transfer portion 3802a may be disposed to face at least a partial surface of the at least one second element 572a, and the second cooling member 3802b may be disposed to face at least a partial surface of the second heat transfer portion 3802a. At least a partial surface of the second cooling member 3802b may face at least a partial surface of the second heat transfer portion 3802a, and at least another partial surface opposite at least the partial surface of the second cooling member 3802b may face at least a partial surface of the opposite end 3803b of the heat transfer member 3803.

As shown in FIGS. 17A and 17B described above, a third cooling member 3901 and a fourth cooling member 3902 may be included in the hinge structure 564. For example, the third cooling member 3901 and the fourth cooling member 3902 may be disposed in a space formed in the Y-axis direction of the hinge structure 564. The third cooling member 3901 may be disposed to face at least a partial surface of the heat transfer member 3803. The fourth cooling member 3902 may be disposed to face at least a partial surface of the heat transfer member 3803.

In this state, for example, the heat A1 generated in the first element 571a and transferred to the heat transfer member 3803 may be transferred both to the hinge structure 564 and to the third cooling member 3901, and the transferred heat A1 may be primarily cooled by the third cooling member 3901. At this time, the remaining heat A1 that has not yet been cooled by the third cooling member 3901 may be transferred to the fourth cooling member 3902. At this time, the transferred heat A1 may be secondarily cooled by the fourth cooling member 3902. For example, the heat A1 may flow (A2) from the third cooling member 3901 to the fourth cooling member 3902 through the heat transfer member 3803, or the heat A1 may flow (A2) from the first housing structure 510 to the second housing structure 520.

As another example, the heat A1-1 generated in the second element 572a and transferred to the heat transfer member 3803 may be transferred both to the hinge structure 564 and to the fourth cooling member 3902, and the transferred heat A1-1 may be primarily cooled by the fourth cooling member 3902. At this time, the remaining heat A1-1 that has not yet been cooled by the fourth cooling member 3902 may be transferred to the third cooling member 3901. At this time, the transferred heat A1-1 may be secondarily cooled by the third cooling member 3901. For example, the heat A1-1 may flow (A2-1) from the fourth cooling member 3902 to the third cooling member 3901 through the heat transfer member 3803, or the heat A1-1 may flow (A2-1) from the second housing structure 520 to the first housing structure 510.

As described above, the third and fourth cooling members 3901 and 3902 may cool the heat A1 and A1-1 transferred to the space formed in the Y-axis direction in the hinge structure 564 so that the heat A1 and A1-1 transferred from the heat transfer member 3803 may be primarily cooled by the third and fourth cooling structures 3901 and 3902 of the hinge structure 564. Accordingly, the heat A1 and A1-1 transferred to the heat transfer member 3803 may be cooled more effectively. Therefore, the temperature of the at least one first or second element 571a or 572a or the temperature of the hinge space of the foldable electronic device 500 may be lowered.

As another example, as shown in FIG. 17A mentioned above, the heat A1 transferred to the third and fourth cooling structures 3901 and 3902 may be transferred to the space formed in the Y-axis direction of the hinge structure 564, and the transferred heat may be applied to the folding portion R1 formed in the flexible display 530 included in the first and second housing structures 510 and 520. For example, since the transferred heat A1 is applied to the folding portion R1 of the flexible display 530, the applied heat A1 may prevent the folding portion R1 from being deformed. For example, the folding portion R1 of the flexible display 530 may prevent the formation of fold marks produced by repeated folding or unfolding of the flexible display using the applied heat A1. In addition, the folding portion R1 may prevent cracks and damage caused by an external environment (e.g., cold weather).

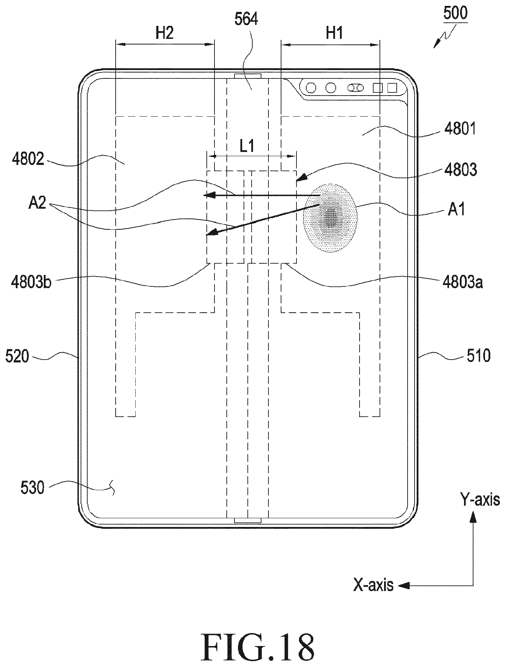

FIG. 18 is a diagram heat A1 distribution and heat transfer paths A2 of some elements included in a foldable electronic device 500 when the foldable electronic device is in an unfolded state according to various embodiments of the disclosure, which illustrates another configuration of a heat transfer structure (e.g., the heat transfer structure 3800 in FIG. 16) and illustrates the side surface width L1 of a heat transfer member 4803 and the side surface widths H1 and H2 of the first and second cooling members 4801 and 4802 in the configuration of the heat transfer structure (e.g., the heat transfer structure 3800 in FIG. 16).

Example: At least one of the elements of the foldable electronic device 500 including the heat transfer structures may be the same as or similar to at least one of the elements of the foldable electronic device 500 including the heat transfer structure 3800 in FIG. 16, so duplicate descriptions thereof will be omitted below..

Referring to FIG. 18, the heat transfer structure (e.g., the heat transfer structure 3800 in FIG. 16) may include first and second heat transfer regions (e.g., the first and second heat transfer regions 3801 and 3802 in FIG. 16), first and second cooling members 4801 and 4802, and a heat transfer member 4803. For example, when the first and second housing structures 510 and 520 are viewed from above in the unfolded state, the first cooling member 4801 may be included in the first housing structure 510, and the second cooling member 4802 may be included in the second housing structure 520.

At least one surface of the first cooling member 4801 may face a first surface 4803a of the heat transfer member 4803, and at least one surface of the second cooling member 4802 may face a second surface 4803b of the heat transfer member 4803.

In this state, the side surface width L1 of the heat transfer member 4803 may be formed to be smaller than the side surface widths H1 and H2 of the first and second cooling members 4801 and 4802, so that the heat A1 transferred to the first heat transfer region (e.g., the first heat transfer region 3801 in FIG. 17B) may be rapidly transferred to the first and second cooling members 4801 and 4802 by the heat transfer member 4803 to be diffused, cooled, or dispersed through the first and second cooling members 4801 and 4802. For example, the first and second cooling members 4801 and 4802 may primarily cool the heat A1 transferred to the first heat transfer region (e.g., the first heat transfer region 3801 in FIG. 17B), and the remaining heat A1 that has not yet been cooled may be transferred to the heat transfer member 4803. For example, the heat transfer member 4803 may transfer more efficiently the high-temperature heat A1, which is transferred from the first heat transfer region (e.g., the first heat transfer region 3801 in FIG. 17B), to the second heat transfer region (e.g., the second heat transfer region 3802 in FIG. 17B) in a lower-temperature state. Accordingly, the heat A1 may flow (A2) from the first cooling member 4801 to the second cooling member 4802 through the heat transfer member 4803, and the heat A1 may also flow (A2) from the first housing structure 510 to the second housing structure 520 through the heat transfer member 4803.

As another example, the heat A1-1 transferred to the second heat transfer region (e.g., the second heat transfer region 3802 in FIG. 17B) may be rapidly transferred to the first and second cooling members 4801 and 4802 by the heat transfer member 4803 to be diffused, cooled, or dispersed through the first and second cooling members 4801 and 4802. For example, the first and second cooling members 4801 and 4802 may primarily cool the heat A1 transferred to the second heat transfer region (e.g., the second heat transfer region 3802 in FIG. 17B). At this time, the remaining heat A1 that has not yet been cooled may be transferred to the heat transfer member 4803. For example, the heat transfer member 4803 may more efficiently transfer the high-temperature heat A1 transferred from the second heat transfer region (e.g., the second heat transfer region 3802 in FIG. 17B) to the first heat transfer region (e.g., the first heat transfer region 3801 in FIG. 17B) in a lower-temperature state. The heat A1 may flow (A2-1) from the second cooling member 4802 to the first cooling member 4801 through the heat transfer member 4803. In addition, the heat A1 may flow (A2-1) from the second housing structure 520 to the first housing structure 510 through the heat transfer member 4803.

Accordingly, the overall size of the heat transfer member 4803 may be smaller than the overall sizes of the first and second cooling members 4801 and 4802, so that the heat transfer member 4803 may transfer more effectively the high-temperature heat A1 or A1-1 generated in the at least one first or second element (e.g., the at least one first or second element 571a or 572a in FIG. 17B) to the first and second cooling members 4801 and 4802. Therefore, the heat transfer member 4803 may further improve the heat transfer function.

According to various embodiments of the disclosure, an electronic device (e.g., the electronic device 200 in FIG. 2) may include a hinge structure (e.g., the hinge structure 564 in FIG. 5B), a first housing structure (e.g., the first housing structure 510 in FIG. 5B) rotatably connected through the hinge structure, a second housing structure (e.g., the second housing structure 520 in FIG. 5B) rotatably connected through the hinge structure and facing the first housing structure with respect to the hinge structure in a folded status, a first fastening member (e.g., the first fastening member 501 in FIG. 5B) mounted on the hinge structure, a second fastening member (e.g., the first fastening member 502 in FIG. 5B) mounted on the hinge structure, and configured to be separated from the first fastening member in the folded status and be coupled to the first fastening member in an unfolded status of the first housing structure and the second housing structure, a first printed circuit board (e.g., the first printed circuit board 571 in FIG. 5B) disposed in the first housing structure and having at least one first element (e.g., the first element 571a in FIG. 5B) mounted thereon, a first heat transfer structure (e.g., the first heat transfer structure 580 in FIG. 5B) disposed in at least a portion of the first housing structure and in at least a portion of the hinge structure, and a second heat transfer member (e.g., the second heat transfer member 592 in FIG. 5B) disposed in at least a portion of the second housing structure and in at least a portion of the hinge structure, wherein the first heat transfer structure may include a first heat transfer region (e.g., the first heat transfer region 581 in FIG. 5B) facing at least a partial surface of the at least one first element, and a first heat transfer member (e.g., the first heat transfer member 582 in FIG. 5B) disposed in at least a partial surface of the first heat transfer region and in at least a portion of the first fastening member, and wherein at least a portion of the first heat transfer member and at least a portion of the second heat transfer member may face each other in the unfolded status, and the first heat transfer member and the second heat transfer member may be separated in the folded status.

According to various embodiments of the disclosure, the first heat transfer member may be configured to transfer, to the second heat transfer member, heat of the at least one first element transferred to the first heat transfer region in the unfolded status.

According to various embodiments of the disclosure, the first heat transfer member or the second heat transfer member may include at least one of a heat pipe, a heat chamber, or a graphite or copper sheet.

According to various embodiments of the disclosure, the first heat transfer region may include a first heat transfer portion (e.g., the first heat transfer portion 582 in FIG. 5B) disposed to face at least a partial surface of the at least one first element, a first cooling member (e.g., the first cooling member 581b in FIG. 5B) disposed to face at least a partial surface of the first heat transfer portion, and a second heat transfer portion (e.g., the second heat transfer portion 581c in FIG. 5B) disposed to face at least a partial surface of the first cooling member, wherein a first surface of the second heat transfer portion may face at least a partial surface of the first cooling member, and a second surface opposite the first surface of the second heat transfer portion may face at least a partial surface of the first heat transfer member.

According to various embodiments of the disclosure, an electronic device (e.g., the electronic device 200 in FIG. 2) may further include a second printed circuit board (e.g., the second printed circuit board 572 in FIG. 5B) disposed in the second housing structure and having at least one second element (e.g., the at least one second element 572a in FIG. 5B) mounted thereon, and a second heat transfer structure (e.g., the second heat transfer structure 590 in FIG. 5B) disposed in at least a portion of the second housing structure and in at least a portion of the hinge structure, wherein the second heat transfer structure may include a second heat transfer region (e.g., the second heat transfer region 591 in FIG. 5B) facing at least a partial surface of the at least one second element, and a second heat transfer member (e.g., the second heat transfer member 592 in FIG. 5B) disposed in at least a partial surface of the second heat transfer region and in at least a portion of the second fastening member, and wherein the second heat transfer member may be configured to transfer, to the first heat transfer member, the heat of the at least one second element transferred to the second heat transfer region in the state in which at least partial surfaces of the first and second heat transfer members face each other.

According to various embodiments of the disclosure, the second heat transfer region may include a third heat transfer portion (e.g., the third heat transfer portion 591a in FIG. 5B) disposed to face at least a partial surface of the at least one second element, a second cooling member (e.g., the second cooling member 591b in FIG. 5B) disposed to face at least a partial surface of the third heat transfer portion, and a fourth heat transfer portion (e.g., the fourth heat transfer portion 591c in FIG. 5B) disposed to face at least a partial surface of the second cooling member, wherein a first surface of the fourth heat transfer portion may face at least a partial surface of the second cooling member, and a second surface opposite the first surface of the fourth heat transfer portion may face at least a partial surface of the second heat transfer member.

According to various embodiments of the disclosure, the first cooling member or the second cooling member may include at least one of a heat pipe or a heat chamber.

According to various embodiments of the disclosure, the hinge structure may further include a third cooling member (e.g., the third cooling member 903 in FIG. 12B) and a fourth cooling member (e.g., the fourth cooling member 904 in FIG. 12B).

According to various embodiments of the disclosure, when the electronic device is viewed from above in the unfolded status, side surface widths of the first heat transfer member and the second heat transfer member may be formed to be smaller than side surface widths of the first cooling member and the second cooling member.

According to various embodiments of the disclosure, the hinge structure may include a first hinge member and a second hinge member, wherein the first fastening member may include a first seat portion (e.g., the first seat portion 501a in FIG. 5B) connected to the first hinge member and a first magnet (e.g., the first magnet 501b in FIG. 5B) seated on the first seat portion, wherein the second fastening member may include a second seat portion (e.g., the second seat portion 502a in FIG. 5B) connected to the second hinge member and a second magnet (e.g., the second magnet 502b in FIG. 5B) seated on the second seat portion.

According to various embodiments of the disclosure, the hinge structure may include a first hinge member and a second hinge member, wherein the first fastening member may include a first fastening portion (e.g., the first fastening portion 601 in FIG. 10B) connected to the first hinge member, and wherein the second fastening member may include a second fastening portion (e.g., the second fastening portion 602 in FIG. 10B) connected to the second hinge member and configured to be coupled to the first fastening portion in the folded status and be separated from the first fastening portion in the unfolded status.

According to various embodiments of the disclosure, the electronic device may be configured to further include a first buffer (e.g., the first buffer 701 in FIG. 8) positioned between the first heat transfer member and the first fastening member, and a second buffer (e.g., the second buffer 702 in FIG. 8) positioned between the second heat transfer member and the second fastening member.

According to various embodiments of the disclosure, the electronic device (e.g., the electronic device 200 in FIG. 2) may further include a hinge cover configured to cover the hinge structure, and a phase change material (e.g., the phase change material 703 in FIG. 9) in contact with the first heat transfer member and the second heat transfer member in the hinge cover and configured to transfer heat of the first heat transfer member to the second heat transfer member.

According to various embodiments of the disclosure, the first heat transfer region may include a first heat transfer portion disposed to face at least a partial surface of the at least one first element, and a first cooling member disposed to face at least a partial surface of the first heat transfer portion, wherein a first surface of the first cooling member may face at least a partial surface of the first heat transfer portion, and a second surface opposite the first surface of the first cooling member may face at least a partial surface of the first heat transfer member.

According to various embodiments of the disclosure, the electronic device (e.g., the electronic device 200 in FIG. 2) may further include a second printed circuit board disposed in the second housing structure and having at least one second element (e.g., the element 571b in FIGS. 11A and B) mounted thereon, and a second heat transfer structure (e.g., the second heat transfer structure 900 in FIGS. 11A and B) disposed in at least a portion of the second housing structure and in at least a portion of the hinge structure, wherein the second heat transfer structure may include a second heat transfer region (e.g., the second heat transfer region 901 in FIGS. 11A and B) facing at least a partial surface of the at least one second element and the second heat transfer member (e.g., the second heat transfer member 902 in FIGS. 11A and B) disposed in at least a partial surface of the second heat transfer region and in at least a portion of the second fastening member, wherein the second heat transfer region may include a second heat transfer portion (e.g., the second heat transfer portion 901a in FIGS. 11A and B) disposed to face at least a partial surface of the at least one second element, and a second cooling member (e.g., the second cooling member 901b in FIGS. 11A and B) disposed to face at least a partial surface of the second heat transfer portion, and wherein a first surface of the second cooling member may face at least a partial surface of the second heat transfer portion, and a second surface opposite the first surface of the second cooling member may face at least a partial surface of the second heat transfer member.

According to various embodiments of the disclosure, an electronic device (e.g., the electronic device 200 in FIG. 2) may include a hinge structure, a first housing structure rotatably connected through the hinge structure, a second housing structure rotatably connected through the hinge structure and facing the first housing structure with respect to the hinge structure in a folded status, a first fastening member mounted on the hinge structure, a second fastening member mounted on the hinge structure, and configured to be separated from the first fastening member in the folded status and be coupled to the first fastening member in an unfolded status of the first housing structure and the second housing structure, a first printed circuit board disposed in the first housing structure and having at least one first element mounted thereon, a second printed circuit board disposed in the second housing structure and having at least one second element mounted thereon, and a heat transfer structure disposed in at least portions of the first housing and the second housing structure and in at least a portion of the hinge structure, wherein the heat transfer structure may include a first heat transfer region facing at least a partial surface of the at least one first element, a second heat transfer region facing at least a partial surface of the at least one second element, and a heat transfer member (e.g., the heat transfer member 2583 in FIG. 14B) disposed between the first heat transfer region and the second heat transfer region and facing at least partial surfaces of the first heat transfer region and the second heat transfer region.

According to various embodiments of the disclosure, the heat transfer member may be configured to transfer, to the second heat transfer region, heat of the at least one first element transferred to the first heat transfer region in the unfolded status or the folded status

According to various embodiments of the disclosure, the heat transfer member may be configured to transfer, to the first heat transfer region, heat of the at least one second element transferred to the second heat transfer region in the unfolded status or the folded status.

According to various embodiments of the disclosure, the first heat transfer region may include a first heat transfer portion disposed to face at least a partial surface of the at least one first element, a first cooling member disposed to face at least a partial surface of the first heat transfer portion, and a second heat transfer portion disposed to face at least a partial surface of the first cooling member, wherein at least a partial surface of the second heat transfer portion may face at least a partial surface of the first cooling member, and at least another partial surface opposite at least the partial surface of the second heat transfer portion may face at least a partial surface of one end of the heat transfer member, wherein the second heat transfer region may include a third heat transfer portion disposed to face at least a partial surface of the at least one second element, a second cooling member disposed to face at least a partial surface of the third heat transfer portion, and a fourth heat transfer portion disposed to face at least a partial surface of the second cooling member, and wherein at least a partial surface of the fourth heat transfer portion may face at least a partial surface of the second cooling member, and at least another partial surface opposite at least the partial surface of the fourth heat transfer portion may face at least a partial surface of the opposite end of the heat transfer member.

According to various embodiments of the disclosure, the first heat transfer region may include a first heat transfer portion disposed to face at least a partial surface of the at least one first element, and a first cooling member disposed to face at least a partial surface of the first heat transfer portion, wherein at least a partial surface of the first cooling member may face at least a partial surface of the first heat transfer portion, and at least another partial surface opposite at least the partial surface of the first cooling member may face at least a partial surface of the heat transfer member, wherein the second heat transfer region may include a second heat transfer portion disposed to face at least a partial surface of the at least one second element, and a second cooling member disposed to face at least a partial surface of the second heat transfer portion, and wherein at least a partial surface of the second cooling member may face at least a partial surface of the second heat transfer portion, and at least another partial surface opposite at least the partial surface of the second cooling member may face at least a portion of the opposite end of the heat transfer member.

According to various embodiments of the disclosure, the hinge structure may further include a third cooling member (e.g., the third cooling member 3901 in FIG. 17B) and a fourth cooling member (e.g., the fourth cooling member 3902 in FIG. 17B).

According to various embodiments of the disclosure, an electronic device (e.g., the electronic device 200 in FIG. 2) may include a hinge structure, a first housing structure rotatably connected through the hinge structure, a second housing structure rotatably connected through the hinge structure and facing the first housing structure with respect to the hinge structure in a folded status, a first fastening member mounted on the hinge structure, a second fastening member mounted on the hinge structure, and configured to be separated from the first fastening member in the folded status and be coupled to the first fastening member in an unfolded status of the first housing structure and the second housing structure, a first printed circuit board disposed in the first housing structure and having at least one first element mounted thereon, a second printed circuit board disposed in the second housing structure and having at least one second element mounted thereon, a first heat transfer structure disposed in at least a portion of the first housing structure and in at least a portion of the hinge structure, and a second heat transfer structure disposed in at least a portion of the second housing structure and in at least a portion of the hinge structure, wherein the first heat transfer structure may include a first heat transfer region facing at least a partial surface of the at least one first element, and a first heat transfer member disposed in at least a partial surface of the first heat transfer region and in at least a portion of the first fastening member, wherein the second heat transfer structure may include a second heat transfer region facing at least a partial surface of the at least one second element, and a second heat transfer member disposed in at least a partial surface of the second heat transfer region and in at least a portion of the second fastening member, wherein at least a portion of the first heat transfer member and at least a portion of the second heat transfer member face each other in the unfolded status, and the first heat transfer member and the second heat transfer member may be separated in the folded status, and wherein, in the unfolded status, the first heat transfer member may transfer, to the second heat transfer member, heat of the at least one first element transferred to the first heat transfer region, and the second heat transfer member may transfer, to the first heat transfer member, heat of the at least one second element transferred to the second heat transfer region.

The foldable electronic device including the heat transfer structure of various embodiments of the disclosure described above is not limited to the above-described embodiments and drawings, and it will be obvious to those of ordinary skill in the art to which the disclosure pertains that various substitutions, modifications, and changes are possible within the technical scope of the disclosure.

## Claims

1. An electronic device comprising:
a hinge structure;
a first housing structure rotatably connected through the hinge structure;
a second housing structure rotatably connected through the hinge structure and facing the first housing structure with respect to the hinge structure in a folded status;
a first fastening member mounted on the hinge structure;
a second fastening member mounted on the hinge structure, and configured to be separated from the first fastening member in the folded status and be coupled to the first fastening member in an unfolded status of the first housing structure and the second housing structure;
a first printed circuit board disposed in the first housing structure and having at least one first element mounted thereon;
a first heat transfer structure disposed in at least a portion of the first housing structure and in at least a portion of the hinge structure; and
a second heat transfer member disposed in at least a portion of the second housing structure and in at least a portion of the hinge structure,
wherein the first heat transfer structure comprises:
a first heat transfer region facing at least a partial surface of the at least one first element; and
a first heat transfer member disposed in at least a partial surface of the first heat transfer region and in at least a portion of the first fastening member, and
wherein at least a portion of the first heat transfer member and at least a portion of the second heat transfer member face each other in the unfolded status, and the first heat transfer member and the second heat transfer member are separated in the folded status.

2. The electronic device of claim 1, wherein the first heat transfer member is configured to transfer, to the second heat transfer member, heat of the at least one first element transferred to the first heat transfer region in the unfolded status.

3. The electronic device of claim 1, wherein the first heat transfer member or the second heat transfer member comprises at least one of a heat pipe, a heat chamber, or a graphite or copper sheet.

4. The electronic device of claim 1, wherein the first heat transfer region comprises: a first heat transfer portion disposed to face at least a partial surface of the at least one first element;
a first cooling member disposed to face at least a partial surface of the first heat transfer portion; and
a second heat transfer portion disposed to face at least a partial surface of the first cooling member, and
wherein a first surface of the second heat transfer portion faces at least a partial surface of the first cooling member, and a second surface opposite the first surface of the second heat transfer portion faces at least a partial surface of the first heat transfer member.

5. The electronic device of claim 4, further comprising a second printed circuit board disposed in the second housing structure and having at least one second element mounted thereon, and a second heat transfer structure disposed in at least a portion of the second housing structure and in at least a portion of the hinge structure,
wherein the second heat transfer structure comprises:
a second heat transfer region facing at least a partial surface of the at least one second element; and
a second heat transfer member disposed in at least a partial surface of the second heat transfer region and in at least a portion of the second fastening member,
wherein the second heat transfer member is configured to transfer, to the first heat transfer member, the heat of the at least one second element transferred to the second heat transfer region in the unfolded status,
wherein the second heat transfer region comprises: a third heat transfer portion disposed to face at least a partial surface of the at least one second element;
a second cooling member disposed to face at least a partial surface of the third heat transfer portion; and
a fourth heat transfer portion disposed to face at least a partial surface of the second cooling member,
wherein a first surface of the fourth heat transfer portion faces at least a partial surface of the second cooling member, and a second surface opposite the first surface of the fourth heat transfer portion faces at least a partial surface of the second heat transfer member, and
wherein the first cooling member or the second cooling member comprises at least one of a heat pipe or a heat chamber.

6. The electronic device of claim 5, wherein the hinge structure further comprises a third cooling member and a fourth cooling member.

7. The electronic device of claim 5, wherein when the electronic device is viewed from above in the unfolded status, side surface widths of the first heat transfer member and the second heat transfer member are formed to be smaller than side surface widths of the first cooling member and the second cooling member.

8. The electronic device of claim 1, wherein the hinge structure comprises a first hinge member and a second hinge member,
wherein the first fastening member comprises a first seat portion connected to the first hinge member and a first magnet seated on the first seat portion,
wherein the second fastening member comprises a second seat portion connected to the second hinge member and a second magnet seated on the second seat portion,
wherein the hinge structure comprises a first hinge member and a second hinge member,
wherein the first fastening member comprises a first fastening portion connected to the first hinge member, and
wherein the second fastening member comprises a second fastening portion connected to the second hinge member and configured to be coupled to the first fastening portion in the folded status and be separated from the first fastening portion in the unfolded status.

9. The electronic device of claim 1, further comprising a first buffer positioned between the first heat transfer member and the first fastening member, and a second buffer positioned between the second heat transfer member and the second fastening member.

10. The electronic device of claim 1, further comprising a hinge cover covering the hinge structure, and
a phase change material in contact with the first heat transfer member and the second heat transfer member in the hinge cover and transfering heat of the first heat transfer member to the second heat transfer member.

11. The electronic device of claim 1, wherein the first heat transfer region comprises: a first heat transfer portion disposed to face at least a partial surface of the at least one first element; and
a first cooling member disposed to face at least a partial surface of the first heat transfer portion, and
wherein a first surface of the first cooling member faces at least a partial surface of the first heat transfer portion, and a second surface opposite the first surface of the first cooling member faces at least a partial surface of the first heat transfer member.

12. The electronic device of claim 11, further comprising:
a second printed circuit board disposed in the second housing structure and having at least one second element mounted thereon; and
a second heat transfer structure disposed in at least a portion of the second housing structure and in at least a portion of the hinge structure,
wherein the second heat transfer structure comprises a second heat transfer region facing at least a partial surface of the at least one second element and the second heat transfer member disposed in at least a partial surface of the second heat transfer region and in at least a portion of the second fastening member,
wherein the second heat transfer region comprises: a second heat transfer portion disposed to face at least a partial surface of the at least one second element; and
a second cooling member disposed to face at least a partial surface of the second heat transfer portion, and
wherein a first surface of the second cooling member faces at least a partial surface of the second heat transfer portion, and a second surface opposite the first surface of the second cooling member faces at least a partial surface of the second heat transfer member.

13. The electronic device of claim 1, comprising: a second printed circuit board disposed in the second housing structure and having at least one second element mounted thereon; and
a second heat transfer structure disposed in at least a portion of the second housing structure and in at least a portion of the hinge structure,
wherein the second heat transfer structure comprises: a second heat transfer region facing at least a partial surface of the at least one second element; and
a second heat transfer member disposed in at least a partial surface of the second heat transfer region and in at least a portion of the second fastening member, and
wherein, in the unfolded status, the first heat transfer member is configured to transfer heat of the at least one first element transferred to the first heat transfer region to the second heat transfer member, and the second heat transfer member is configured to transfer heat of the at least one second element transferred to the second heat transfer region to the first heat transfer member.

14. An electronic device comprising:
a hinge structure;
a first housing structure rotatably connected through the hinge structure;
a second housing structure rotatably connected through the hinge structure and facing the first housing structure with respect to the hinge structure in a folded status;
a first fastening member mounted on the hinge structure;
a second fastening member mounted on the hinge structure, and be separated from the first fastening member in the folded status and be coupled to the first fastening member in an unfolded status of the first housing structure and the second housing structure;
a first printed circuit board disposed in the first housing structure and having at least one first element mounted thereon;
a second printed circuit board disposed in the second housing structure and having at least one second element mounted thereon; and
a heat transfer structure disposed in at least portions of the first housing and the second housing structure and in at least a portion of the hinge structure,
wherein the heat transfer structure comprises:
a first heat transfer region facing at least a partial surface of the at least one first element;
a second heat transfer region facing at least a partial surface of the at least one second element; and
a heat transfer member disposed between the first heat transfer region and the second heat transfer region and facing at least partial surfaces of the first heat transfer region and the second heat transfer region.

15. The electronic device of claim 14, wherein the heat transfer member is configured to transfer, to the second heat transfer region, heat of the at least one first element transferred to the first heat transfer region in the unfolded status or the folded status, and
wherein the heat transfer member is configured to transfer, to the first heat transfer region, heat of the at least one second element transferred to the second heat transfer region in the unfolded status or the folded status.

16. The electronic device of claim 14, wherein the first heat transfer region comprises: a first heat transfer portion disposed to face at least a partial surface of the at least one first element;
a first cooling member disposed to face at least a partial surface of the first heat transfer portion; and
a second heat transfer portion disposed to face at least a partial surface of the first cooling member,
wherein at least a partial surface of the second heat transfer portion faces at least a partial surface of the first cooling member, and at least another partial surface opposite at least the partial surface of the second heat transfer portion faces at least a partial surface of one end of the heat transfer member,
wherein the second heat transfer region comprises: a third heat transfer portion disposed to face at least a partial surface of the at least one second element;
a second cooling member disposed to face at least a partial surface of the third heat transfer portion; and
a fourth heat transfer portion disposed to face at least a partial surface of the second cooling member, and
wherein at least a partial surface of the fourth heat transfer portion faces at least a partial surface of the second cooling member, and at least another partial surface opposite at least the partial surface of the fourth heat transfer portion faces at least a partial surface of the opposite end of the heat transfer member.

17. The electronic device of claim 14, wherein the first heat transfer region comprises: a first heat transfer portion disposed to face at least a partial surface of the at least one first element; and
a first cooling member disposed to face at least a partial surface of the first heat transfer portion,
wherein at least a partial surface of the first cooling member faces at least a partial surface of the first heat transfer portion, and at least another partial surface opposite at least the partial surface of the first cooling member faces at least a partial surface of the heat transfer member,
wherein the second heat transfer region comprises a second heat transfer portion disposed to face at least a partial surface of the at least one second element; and
a second cooling member disposed to face at least a partial surface of the second heat transfer portion, and
wherein at least a partial surface of the second cooling member faces at least a partial surface of the second heat transfer portion, and at least another partial surface opposite at least the partial surface of the second cooling member faces at least a portion of the opposite end of the heat transfer member.
